# EUROPEAN PATENT APPLICATION

(11) **EP 4 651 207 A1**
(43) Date of publication of application: **19.11.2025**
(21) Application number: 23916148.2
(22) Date of filing: 20.11.2023
(51) Int. Cl.: H01L 27/146, H01L 31/107

(54) **LIGHT DETECTION DEVICE**

(30) Priority: 13.01.2023 JP 2023004149
(71) Applicant: Sony Semiconductor Solutions Corporation, Atsugi-shi, Kanagawa 243-0014 (JP)
(72) Inventor: SUZUKI, Junki, Atsugi-shi, Kanagawa 243-0014 (JP); TSUKUDA, Yasunori, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/041591
(87) International publication number: WO 2024/150531

(57) **Abstract**

A photodetector according to one embodiment of the present disclosure includes a first substrate, a light receiving element, a first contact layer, a second contact layer, a second substrate, a first through wiring, a second through wiring, and one or more first shield electrodes. The first substrate has a first surface and a second surface opposed to each other and includes a pixel array section in which a plurality of pixels is arranged in an array in an in-plane direction. The light receiving element includes a light receiving section and a multiplication section. The light receiving section is provided inside the first substrate for each of the pixels and generates carriers corresponding to a received light amount by photoelectric conversion. The multiplication section performs avalanche multiplication of the carriers generated in the light receiving section. The first contact layer is provided on the first surface of the first substrate and is electrically coupled to the light receiving section. The second contact layer is provided on the first surface of the first substrate and is electrically coupled to the multiplication section. The second substrate is stacked on a side of the first surface of the first substrate and includes a semiconductor layer in which one or more transistors are provided. The first through wiring is provided through the semiconductor layer in a stacking direction and is electrically coupled to the first contact layer. The second through wiring is provided through the semiconductor layer in the stacking direction and is electrically coupled to the second contact layer. The one or more first shield electrodes are provided at least in a portion of a region between the one or more transistors and the first and the second through wirings. A fixed potential is applied to the one or more first shield electrodes. The first and the second through wirings are adjacent to the one or more transistors.

## Description

### Technical Field

The present disclosure relates to a photodetector including, for example, an avalanche photodiode.

### Background Art

For example, PTL 1 discloses a photodetector in which one or more control transistors are provided for each single-photon avalanche diode (SPAD), on a surface of a wafer opposite to a light gathering surface of a SPAD pixel array.

### Citation List

### Patent Literature

PTL 1: Japanese Unexamined Patent Application Publication No. 2022-54459

### Summary of the Invention

Incidentally, regarding a photodetector, it is required to improve a characteristic of a transistor.

It is desirable to provide a photodetector that makes it possible to improve a characteristic of a transistor.

A photodetector according to an embodiment of the present disclosure includes a first substrate, a light receiving element, a first contact layer, a second contact layer, a second substrate, a first through wiring, a second through wiring, and one or more first shield electrodes. The first substrate has a first surface and a second surface opposed to each other and includes a pixel array section in which a plurality of pixels is arranged in an array in an in-plane direction. The light receiving element includes a light receiving section and a multiplication section. The light receiving section is provided inside the first substrate for each of the pixels and generates carriers corresponding to a received light amount by photoelectric conversion. The multiplication section performs avalanche multiplication of the carriers generated in the light receiving section. The first contact layer is provided on the first surface of the first substrate and is electrically coupled to the light receiving section. The second contact layer is provided on the first surface of the first substrate and is electrically coupled to the multiplication section. The second substrate is stacked on a side of the first surface of the first substrate and includes a semiconductor layer in which one or more transistors are provided. The first through wiring is provided through the semiconductor layer in a stacking direction and is electrically coupled to the first contact layer. The second through wiring is provided through the semiconductor layer in the stacking direction and is electrically coupled to the second contact layer. The one or more first shield electrodes are provided at least in a portion of a region between the one or more transistors and the first and the second through wirings. A fixed potential is applied to the one or more first shield electrodes. The first and the second through wirings are adjacent to the one or more transistors.

In the photodetector according to the embodiment of the present disclosure, the one or more first shield electrodes to which the fixed potential is applied are provided at least in a portion of the region between the one or more transistors and the first and the second through wirings. The first and the second through wirings are adjacent to the one or more transistors. The one or more transistors are provided on the side of the first surface of the first substrate. The first through wiring is provided through the semiconductor layer in which the one or more transistors are provided, and is electrically coupled to the first contact layer provided on the first surface of the first substrate in which the light receiving element is provided. The second through wiring is provided through the semiconductor layer, and is electrically coupled to the second contact layer provided on the first surface of the first substrate in which the light receiving element is provided. This blocks an influence of a high voltage applied to the light receiving element.

### Brief Description of the Drawings

[FIG. 1] FIG. 1 is a schematic cross-sectional diagram illustrating an example of a photodetector according to an embodiment of the present disclosure.
[FIG. 2] FIG. 2 is a schematic plan view of the photodetector corresponding to a region A and a region B illustrated in FIG. 1.
[FIG. 3] FIG. 3 is a block diagram illustrating an example of a schematic configuration of the photodetector illustrated in FIG. 1.
[FIG. 4] FIG. 4 is an example of an equivalent circuit diagram of a unit pixel of the photodetector illustrated in FIG. 1.
[FIG. 5A] FIG. 5A is a schematic cross-sectional diagram illustrating an example of a manufacturing method of the photodetector illustrated in FIG. 1.
[FIG. 5B] FIG. 5B is a schematic cross-sectional diagram illustrating a process following that in FIG. 5A.
[FIG. 5C] FIG. 5C is a schematic cross-sectional diagram illustrating a process following that in FIG. 5B.
[FIG. 5D] FIG. 5D is a schematic cross-sectional diagram illustrating a process following that in FIG. 5C.
[FIG. 5E] FIG. 5E is a schematic cross-sectional diagram illustrating a process following that in FIG. 5D.
[FIG. 5F] FIG. 5F is a schematic cross-sectional diagram illustrating a process following that in FIG. 5E.
[FIG. 6] FIG. 6 is a schematic cross-sectional diagram illustrating an example of a photodetector according to Modification example 1 of the present disclosure.
[FIG. 7] FIG. 7 is a schematic plan diagram illustrating an example of a photodetector according to Modification example 2 of the present disclosure.
[FIG. 8] FIG. 8 is a schematic plan diagram illustrating another example of the photodetector according to Modification example 2 of the present disclosure.
[FIG. 9] FIG. 9 is a schematic plan diagram illustrating another example of the photodetector according to Modification example 2 of the present disclosure.
[FIG. 10] FIG. 10 is a schematic plan diagram illustrating another example of the photodetector according to Modification example 2 of the present disclosure.
[FIG. 11] FIG. 11 is a schematic plan diagram illustrating another example of the photodetector according to Modification example 2 of the present disclosure.
[FIG. 12] FIG. 12 is a schematic plan diagram illustrating another example of the photodetector according to Modification example 2 of the present disclosure.
[FIG. 13] FIG. 13 is a schematic plan diagram illustrating another example of the photodetector according to Modification example 2 of the present disclosure.
[FIG. 14] FIG. 14 is a schematic plan diagram illustrating an example of a photodetector according to Modification example 3 of the present disclosure.
[FIG. 15] FIG. 15 is a schematic plan diagram illustrating another example of the photodetector according to Modification example 3 of the present disclosure.
[FIG. 16] FIG. 16 is a schematic plan diagram illustrating another example of the photodetector according to Modification example 3 of the present disclosure.
[FIG. 17] FIG. 17 is a schematic cross-sectional diagram illustrating an example of a photodetector according to Modification example 4 of the present disclosure.
[FIG. 18] FIG. 18 is a schematic plan view of the photodetector corresponding to the region B illustrated in FIG. 17.
[FIG. 19] FIG. 19 is a schematic cross-sectional diagram illustrating another example of the photodetector according to Modification example 4 of the present disclosure.
[FIG. 20] FIG. 20 is a schematic plan view of the photodetector corresponding to the region B illustrated in FIG. 19.
[FIG. 21] FIG. 21 is a schematic cross-sectional diagram illustrating an example of a photodetector according to Modification example 5 of the present disclosure.
[FIG. 22] FIG. 22 is a schematic cross-sectional diagram illustrating another example of the photodetector according to Modification example 5 of the present disclosure.
[FIG. 23] FIG. 23 is a schematic cross-sectional diagram illustrating an example of a photodetector according to Modification example 6 of the present disclosure.
[FIG. 24] FIG. 24 is a schematic plan view of the photodetector corresponding to the region B illustrated in FIG. 23.
[FIG. 25] FIG. 25 is a schematic cross-sectional diagram illustrating an example of a photodetector according to Modification example 7 of the present disclosure.
[FIG. 26] FIG. 26 is a schematic diagram illustrating an example of a plan configuration corresponding to that of the region B illustrated in FIG. 25.
[FIG. 27] FIG. 27 is a schematic diagram illustrating another example of the plan configuration corresponding to that of the region B illustrated in FIG. 25.
[FIG. 28] FIG. 28 is a schematic cross-sectional diagram illustrating an example of a photodetector according to Modification example 8 of the present disclosure.
[FIG. 29] FIG. 29 is a schematic cross-sectional diagram illustrating another example of the photodetector according to Modification example 8 of the present disclosure.
[FIG. 30] FIG. 30 is a schematic cross-sectional diagram illustrating an example of a photodetector according to Modification example 9 of the present disclosure.
[FIG. 31] FIG. 31 is a schematic plan view of the photodetector corresponding to the region B illustrated in FIG. 30.
[FIG. 32] FIG. 32 is a functional block diagram illustrating an example of an electronic apparatus including the photodetector illustrated in FIG. 1, etc.
[FIG. 33] FIG. 33 is a view depicting an example of a schematic configuration of an endoscopic surgery system.
[FIG. 34] FIG. 34 is a block diagram depicting an example of a functional configuration of a camera head and a camera control unit (CCU).
[FIG. 35] FIG. 35 is a block diagram depicting an example of schematic configuration of a vehicle control system.
[FIG. 36] FIG. 36 is a diagram of assistance in explaining an example of installation positions of an outside-vehicle information detecting section and an imaging section.

### Modes for Carrying Out the Invention

In the following, a description is given of embodiments of the present disclosure in detail with reference to the drawings. Described in the following is a specific example of the present disclosure, and the present disclosure is not limited to the following aspect. Moreover, the present disclosure is not limited to arrangements, dimensions, dimensional ratios, and the like of each component illustrated in each of the drawings. Note that the description is given in the following order.
1. Embodiment (A photodetector including a shield electrode between a transistor and a through via that are adjacent to each other)
   1-1. Configuration of Photodetector
   1-2. Manufacturing Method of Photodetector
   1-3. Working and Effects
2. Modification Examples
   2-1. Modification Example 1 (Another example of the photodetector)
   2-2. Modification Example 2 (Another example of the photodetector)
   2-3. Modification Example 3 (Another example of the photodetector)
   2-4. Modification Example 4 (Another example of the photodetector)
   2-5. Modification Example 5 (Another example of the photodetector)
   2-6. Modification Example 6 (Another example of the photodetector)
   2-7. Modification Example 7 (Another example of the photodetector)
   2-8. Modification Example 8 (Another example of the photodetector)
   2-9. Modification Example 9 (Another example of the photodetector)
3. Application Example
4. Practical Application Examples

### <1. First Embodiment>

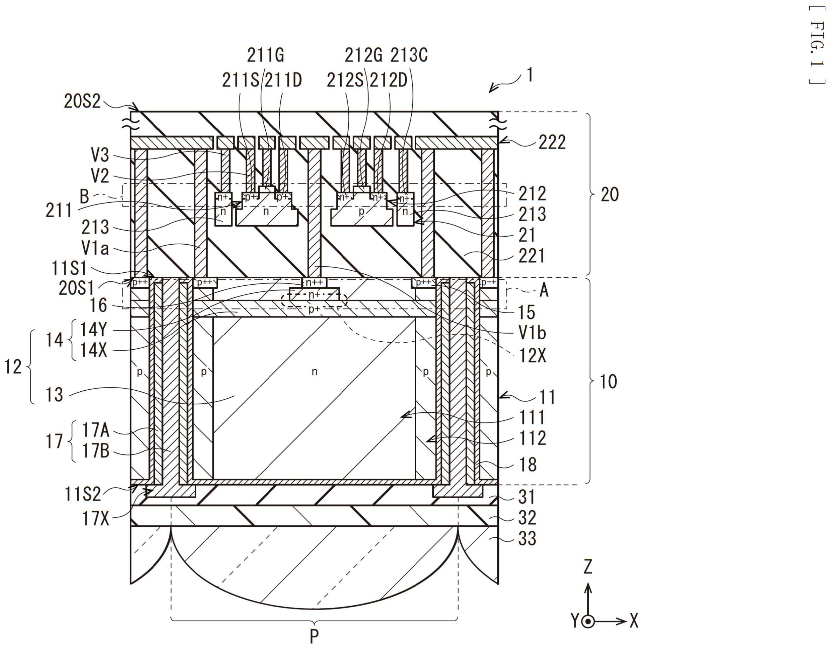

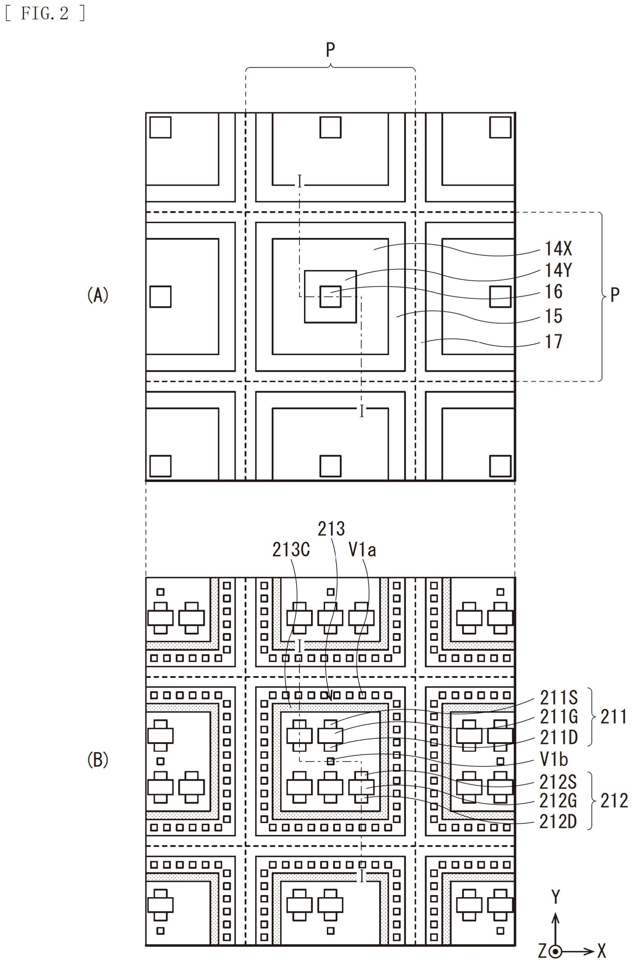

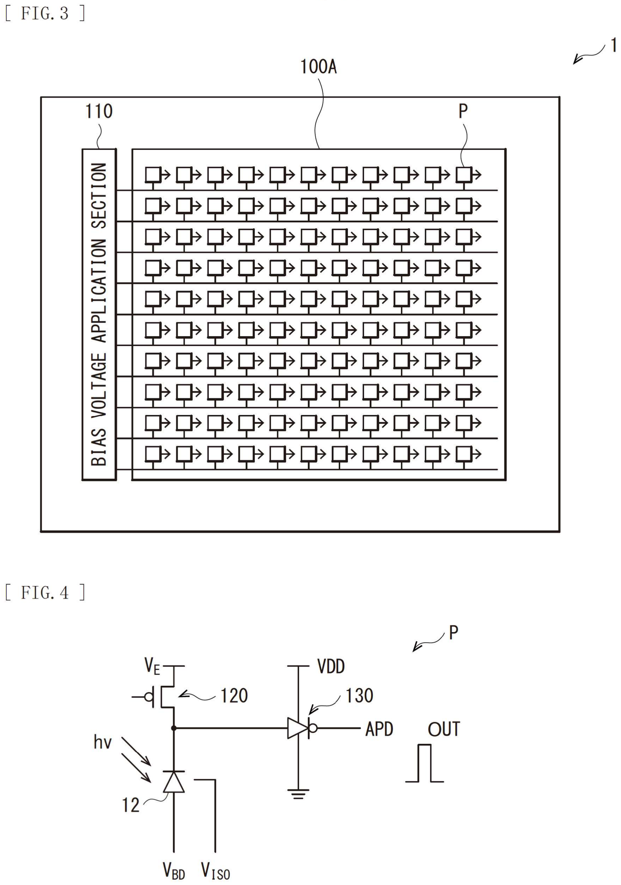

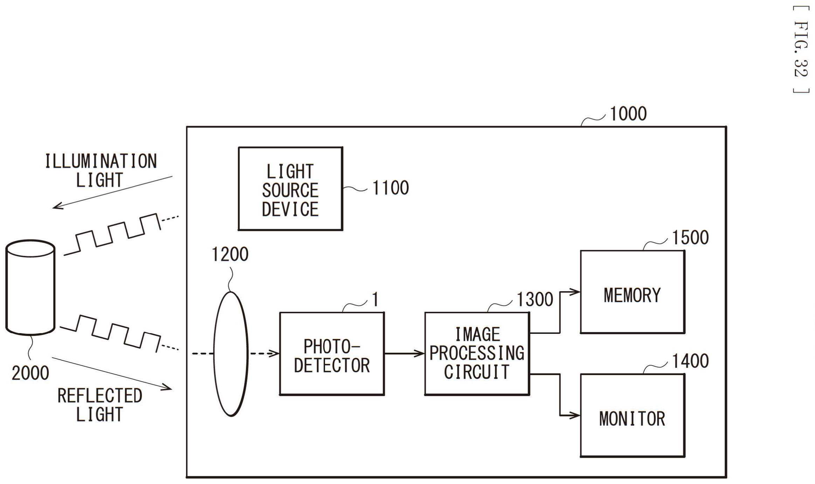

FIG. 1 schematically illustrates an example of a cross-sectional configuration of a photodetector (a photodetector 1) according to an embodiment of the present disclosure. Part (A) of FIG. 2 schematically illustrates a plan configuration corresponding to that of a region A of the photodetector 1 illustrated in FIG. 1. Part (B) of FIG. 2 schematically illustrates a plan configuration corresponding to that of a region B of the photodetector illustrated in FIG. 1. FIG. 1 illustrates a cross section corresponding to line I-I indicated in FIG. 2. FIG. 3 is a block diagram illustrating a schematic configuration of the photodetector 1 illustrated in FIG. 1. FIG. 4 illustrates an example of an equivalent circuit of a unit pixel P of the photodetector 1 illustrated in FIG. 1. The photodetector 1 is applied to, for example, a distance image sensor (a distance image apparatus 1000 to be described later; see FIG. 32) that performs distance measurement by a ToF (Time-of-Flight) method, an image sensor, or the like.

### (1-1. Configuration of Photodetector)

The photodetector 1 includes, for example, a pixel array section 100A in which a plurality of unit pixels P is arranged in an array, in a row direction and a column direction. As illustrated in FIG. 3, the photodetector 1 includes a bias voltage application section 110 together with the pixel array section 100A. The bias voltage application section 110 applies a bias voltage to each of the unit pixels P in the pixel array section 100A. In the present embodiment, a description is given of a case where electrons are read out as signal charge.

As illustrated in FIG. 3, the unit pixel P includes a light receiving element 12, a quenching resistance element 120, and an inverter 130. The quenching resistance element 120 includes, for example, a p-type MOSFET (Metal-Oxide-Semiconductor Field-Effect Transistor). The inverter 130 includes, for example, a complementary-type MOSFET.

The light receiving element 12 converts incident light into an electric signal by photoelectric conversion, and outputs the electric signal. The light receiving element 12 collaterally converts the incident light (photon) into the electric signal by photoelectric conversion, and outputs a pulse corresponding to the incidence of the photon. The light receiving element 12 is, for example, a SPAD (Single Photon Avalanche Diode) element. The SPAD element has, for example, a characteristic in which an avalanche multiplication region 12X (a depletion layer) is formed by application of a large negative voltage to a cathode, electrons generated in response to the incidence of one photon cause avalanche multiplication, and a large current flows. The light receiving element 12 has, for example, an anode coupled to the bias voltage application section 110 and a cathode coupled to a source terminal of the quenching resistance element 120. A device voltage V_{B} is applied from the bias voltage application section 110 to the anode of the light receiving element 12.

The quenching resistance element 120 is coupled in series to the light receiving element 12, and has the source terminal coupled to the cathode of the light receiving element 12 and a drain terminal coupled to an unillustrated power supply. An excitation voltage V_{E} is applied from the power supply to the drain terminal of the quenching resistance element 120. When a voltage of electrons having been subjected to the avalanche multiplication by the light receiving element 12 reaches a negative voltage V_{BD}, the quenching resistance element 120 performs quenching in which the electrons multiplied by the light receiving element 12 are emitted to return the voltage to an initial voltage.

The inverter 130 has an input terminal coupled to the cathode of the light receiving element 12 and to the source terminal of the quenching resistance element 120, and an output terminal coupled to an unillustrated subsequent arithmetic processing section. The inverter 130 outputs a light receiving signal on the basis of the carriers (signal charge) multiplied by the light receiving element 12. More specifically, the inverter 130 shapes a voltage generated by the electrons multiplied by the light receiving element 12. The inverter 130 then outputs a light receiving signal (APD OUT) in which, for example, a pulse waveform illustrated in FIG. 4 is generated, to the arithmetic processing section, with an arrival time of one font as a starting point. For example, the arithmetic processing section performs arithmetic processing of determining a distance to a subject on the basis of a timing at which the pulse indicating the arrival time of one font is generated in each light receiving signal, and determines the distance for each of the unit pixels P. On the basis of the distances, a distance image is then generated in which the distances to the subject detected by the plurality of unit pixels P are arranged in a planar manner.

The photodetector 1 is, for example, what is called a back-illuminated photodetector in which a logic substrate 20 is stacked on a side of a front surface of a sensor substrate 10 (e.g., a side of a front surface (a first surface 11S1) of a semiconductor substrate 11 included in the sensor substrate 10), and light is received from a side of a back surface of the sensor substrate 10 (e.g., a back surface (a second surface 11S2) of the semiconductor substrate 11 included in the sensor substrate 10).

The photodetector 1 includes the light receiving element 12 for each of the unit pixels P. The light receiving element 12 includes a light receiving section 13 and a multiplication section 14. In the photodetector 1, the sensor substrate 10 and the logic substrate 20 are stacked on each other, as described above. The sensor substrate 10 includes, for example, the semiconductor substrate 11 including a silicon substrate, and the light receiving section 13 and the multiplication section 14 are, for example, embedded in the semiconductor substrate 11. The first surface 11S1 of the semiconductor substrate 11 is provided with a contact layer 15 (an anode) electrically coupled to the light receiving section 13, and a contact layer 16 (a cathode) electrically coupled to the multiplication section 14. The semiconductor substrate 11 is further provided with a pixel separation section 17 that electrically separates adjacent unit pixels P from each other. The pixel separation section 17 is provided between the plurality of unit pixels P adjacent to each other in the row direction and the column direction, to extend from the first surface 11S1 to the second surface 11S2 of the semiconductor substrate 11. The pixel separation section 17 is provided in a lattice pattern in a plan view in the pixel array section 100A as a whole. The logic substrate 20 includes, for example, a semiconductor layer 21 embedded in an interlayer insulating layer 221. Provided in the semiconductor layer 21 is, for example, a plurality of transistors (e.g., two p-MOS transistors 211 and three n-MOS transistors 212), which forms, for example, a readout circuit that outputs a pixel signal based on carriers outputted from the unit pixel P (the light receiving element 12). The logic substrate 20 further has through vias V1a and V1b that are provided through the semiconductor layer 21 in a stacking direction (a Z-axis direction) and are electrically coupled to the contact layers 15 and 16, respectively. In the present embodiment, a shield electrode 213 to which a fixed potential is applied is provided between the through via V1a, and the p-MOS transistor 211 and the n-MOS transistor 212 in the logic substrate 20. The through via V1a is adjacent to the p-MOS transistor 211 and the n-MOS transistor 212.

The above-described sensor substrate 10 corresponds to a specific example of a "first substrate" in an embodiment of the present disclosure, and the logic substrate 20 corresponds to a specific example of a "second substrate" in the embodiment of the present disclosure. The contact layer 15 corresponds to a specific example of a "first contact layer" in the embodiment of the present disclosure, and the contact layer 16 corresponds to a specific example of a "second contact layer" in the embodiment of the present disclosure. The through via 1Va corresponds to a specific example of a "first through wiring" in the embodiment of the present disclosure, and the through via 1Vb corresponds to a specific example of a "second through wiring" in the embodiment of the present disclosure. The shield electrode 213 corresponds to a specific example of a "first shield electrode" in the embodiment of the present disclosure.

Note that the symbols "p" and "n" in the diagram represent a p-type semiconductor region and an n-type semiconductor region, respectively. Further, "+" and "-" at the end of "p" each represent an impurity concentration of the p-type semiconductor region. Likewise, "+" and "-" at the end of "n" each represent an impurity concentration of the n-type semiconductor region. Here, the larger number of "+" indicates a higher impurity concentration, and the larger number of "-" indicates a lower impurity concentration. This similarly applies to the drawings described below.

The semiconductor substrate 11 has the first surface 11S1 and the second surface 11S2 opposed to each other. The semiconductor substrate 11 includes a p-well (p) common to the plurality of unit pixels P. The semiconductor substrate 11 is provided with, for each of the unit pixels P, an n-type semiconductor region (n) 111 that constitutes the light receiving section 13. The n-type semiconductor region (n) 111 has an impurity concentration controlled to be, for example, an n-type. The semiconductor substrate 11 is further provided with a p-type semiconductor region (p⁺) 14X and an n-type semiconductor region (n⁺) 14Y that constitute the multiplication section 14 on the side of the first surface 11S1. This allows for formation of the light receiving element 12 for each of the unit pixels P. The pixel separation section 17 is provided around each of the unit pixels P. The pixel separation section 17 electrically separates the adjacent unit pixels P from each other. A p-type semiconductor region (p) 112 having a higher impurity concentration than the p-well is provided between the light receiving element 12 and the pixel separation section 17.

The light receiving element 12 has a multiplication region (an avalanche multiplication region 12X) that performs avalanche multiplication of carriers by a high electric field region. As described above, the light receiving element 12 is the SPAD element that enables the formation of the avalanche multiplication region 12X by application of a large negative voltage to the cathode (the contact layer 16) and that enables the avalanche multiplication of electrons generated by the incidence of one photon.

The light receiving element 12 includes the light receiving section 13 and the multiplication section 14.

The light receiving section 13 corresponds to a specific example of a "light receiving section" of the present disclosure. The light receiving section 13 has a photoelectric conversion function of absorbing light incident from the side of the second surface 11S2 of the semiconductor substrate 11 and generating carriers corresponding to the received light amount. As described above, the light receiving section 13 includes the n-type semiconductor region (n) 111 having the impurity concentration controlled to be the n-type, and carriers (electrons) generated by the light receiving section 13 are transferred to the multiplication section 14 by a potential gradient.

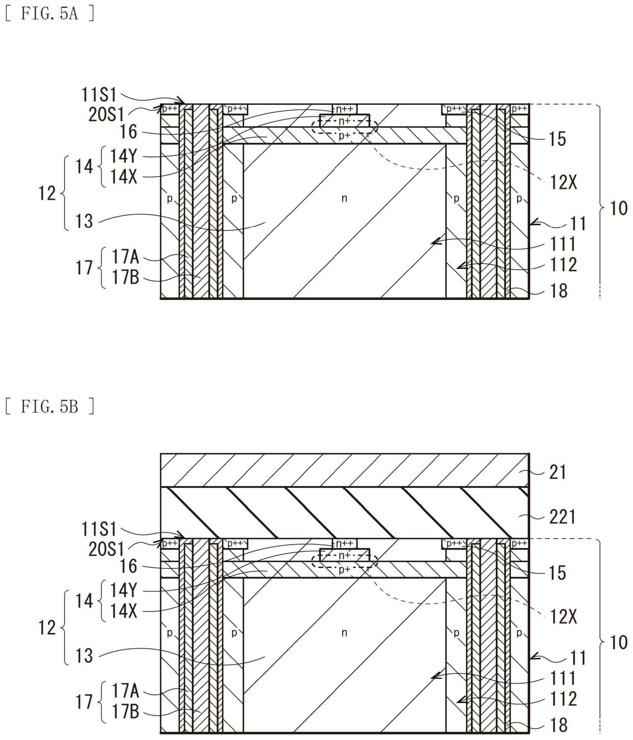

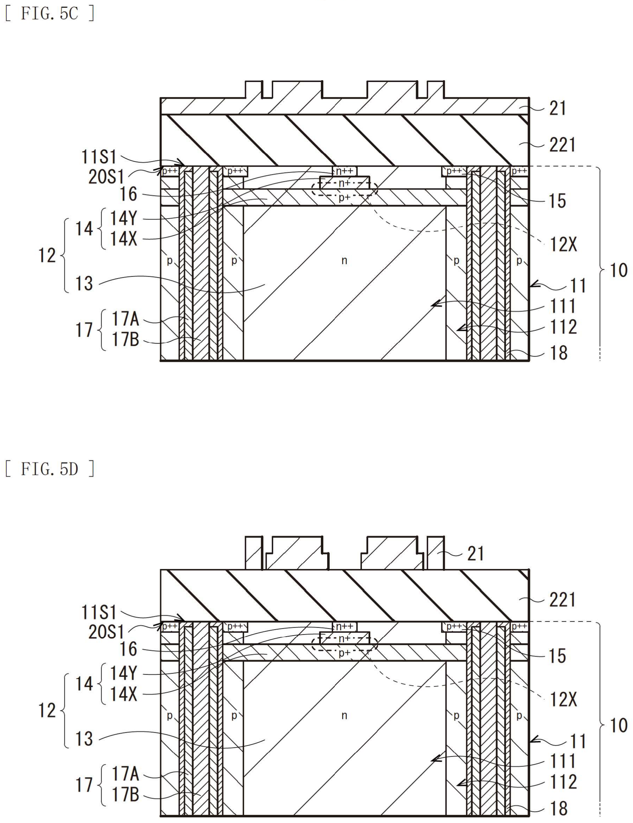

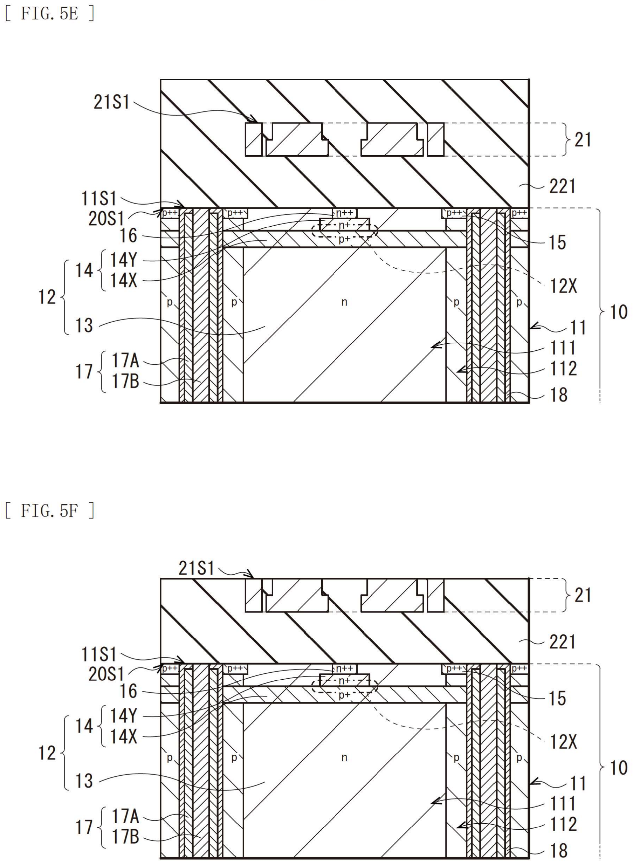

The multiplication section 14 corresponds to a specific example of a "multiplication section" of the present disclosure. The multiplication section 14 performs avalanche multiplication of carriers (here, electrons) generated by the light receiving section 13. The multiplication section 14 includes, for example, the p-type semiconductor region (p⁺) 14X having an impurity concentration higher than the p-well (p), and the n-type semiconductor region (n⁺) 14Y having an impurity concentration higher than that of the n-type semiconductor region (n) 111. The p-type semiconductor region (p⁺) 14X and the n-type semiconductor region (n⁺) 14Y are provided on the side of the first surface 11S1. The n-type semiconductor region (n⁺) 14Y and the p-type semiconductor region (p⁺) 14X are formed to be stacked in this order from the side of the first surface 11S1. An area of the p-type semiconductor region (p⁺) 14X in an XY-plane direction is larger than an area of the n-type semiconductor region (n⁺) 14Y in the XY-plane direction, and is provided, for example, across the entire surface of the unit pixel P partitioned by the pixel separation section 17. However, this is non-limiting. For example, the p-type semiconductor region (p⁺) 14X may be formed, for example, on an inner side of the p-type semiconductor region (p) 112, for example, as illustrated in FIG. 5.

In the light receiving element 12, the avalanche multiplication region 12X is provided at a junction part between the p-type semiconductor region (p⁺) 14X and the n-type semiconductor region (n⁺) 14Y. The avalanche multiplication region 12X is a high electric field region (a depletion layer) formed at an interface between the p-type semiconductor region (p⁺) 14X and the n-type semiconductor region (n⁺) 14Y by a large negative voltage applied to the cathode. In the avalanche multiplication region 12X, electrons (e⁻) generated by one photon incident on the light receiving element 12 are multiplied.

The first surface 11S1 of the semiconductor substrate 11 is further provided with the contact layer 15 and the contact layer 16. The contact layer 15 includes a p-type semiconductor region (p⁺⁺) electrically coupled to the n-type semiconductor region (n) 111 constituting the light receiving section 13. The contact layer 16 includes an n-type semiconductor region (n⁺⁺) electrically coupled to the n-type semiconductor region (n⁺) 14Y constituting the multiplication section 14. For example, as illustrated in part (A) of FIG. 2, the contact layer 15 is provided along the pixel separation section 17 to surround the light receiving section 13, and is coupled to the bias voltage application section 110, as the anode of the light receiving element 12. The contact layer 16 is coupled as the cathode to the source terminal of the quenching resistance element 120.

The pixel separation section 17 electrically separates adjacent unit pixels P from each other. For example, in a plan view, the pixel separation section 17 is provided in a lattice pattern in the pixel array section 100A, to partition the plurality of unit pixels P from each other. The pixel separation section 17 extends between the first surface 11S1 and the second surface 11S2 of the semiconductor substrate 11, and is provided through the semiconductor substrate 11, for example. The pixel separation section 17 includes, for example, an insulating film 17A and a light blocking film 17B embedded in the insulating film 17A. The pixel separation section 17 may be provided from the side of the first surface 11S1 of the semiconductor substrate 11, or may be formed from the side of the second surface 11S2 of the semiconductor substrate 11.

The insulating film 17A includes, for example, silicon oxide (SiOₓ) or the like. The light blocking film 17B includes, for example, a metal material having a light blocking property, such as tungsten (W), aluminum (Al), copper (Cu), cobalt (Co), nickel (Ni), or titanium (Ti), or a silicon compound thereof. Other than the above, the light blocking film 17B may include polysilicon (Poly-Si). The light blocking film 17B may be provided with an increased width section 17X provided to be extended on the second surface 11S2 of the semiconductor substrate 11, for the purpose of suppressing incidence of oblique incident light between adjacent unit pixels P.

A side surface and a bottom surface of the pixel separation section 17 and the second surface 11S2 of the semiconductor substrate 11 may be provided with, for example, a layer (a fixed charge film 18) having fixed charge. The fixed charge film 18 may be a film having positive fixed charge or a film having negative fixed charge.

It is preferable to use, as a constituent material of the fixed charge film 18, a semiconductor material or electrically conductive material having a wider band gap than the semiconductor substrate 11 for the formation. This makes it possible to suppress generation of a dark current at an interface of the semiconductor substrate 11. Examples of the constituent material of the fixed charge film 18 include hafnium oxide (HfOₓ), aluminum oxide (AlOₓ), zirconium oxide (ZrOₓ), tantalum oxide (TaOₓ), titanium oxide (TiOₓ), lanthanum oxide (LaOₓ), praseodymium oxide (PrOₓ), cerium oxide (CeOₓ), neodymium oxide (NdOₓ), promethium oxide (PmOₓ), samarium oxide (SmOₓ), europium oxide (EuOₓ), gadolinium oxide (GdOₓ), terbium oxide (TbOₓ), dysprosium oxide (DyOₓ), holmium oxide (HoOₓ), thulium oxide (TmOₓ), ytterbium oxide (YbOₓ), lutetium oxide (LuOₓ), yttrium oxide (YOₓ), hafnium nitride (HfNₓ), aluminum nitride (AlNₓ), hafnium oxynitride (HfOₓN_{y}), and aluminum oxynitride (AlOₓN_{y}).

The logic substrate 20 includes, for example, the semiconductor layer 21 including a silicon base and the interlayer insulating layer 221 in which the semiconductor layer 21 is embedded. Provided on the logic substrate 20 are, for example, the bias voltage application section 110 and a logic circuit. The logic circuit includes a readout circuit that outputs a pixel signal based on carriers outputted from the unit pixel P in the pixel array section 100A, a vertical drive circuit, a column signal processing circuit, a horizontal drive circuit, an output circuit, and the like.

The semiconductor layer 21 is separated into, for example, a plurality of islands, and a plurality of transistors constituting the above-described circuits is provided in each of the islands into which the semiconductor layer 21 is separated. Specifically, for example, the two p-MOS transistors 211 and the three n-MOS transistors 212 are provided that constitute, for example, the readout circuit that outputs the pixel signal based on the carriers outputted from the light receiving element 12. The p-MOS transistor 211 has, for example, a planar configuration, and includes a gate electrode 211G, a source region 2118S, and a drain region 211D. The source region 211S and the drain region 211D each include a p-type semiconductor region (p⁺). The n-MOS transistor 212 has, for example, a planar configuration, and has a gate electrode 212G, a source region 212S, and a drain region 212D. The source region 212S and the drain region 212D each include an n-type semiconductor region (n⁺). Each semiconductor layer 21 in which the p-MOS transistors 211 and the n-MOS transistors 212 are provided is provided with an unillustrated well contact electrode. The well contact electrode includes an n-type semiconductor region (n⁺) or a p-type semiconductor region (p⁺) for applying a predetermined potential to the semiconductor layer 21.

Further, a part of the plurality of semiconductor layers 21 separated into islands in each of the unit pixels P forms the shield electrode 213. The shield electrode 213 is provided to block potential interference between the through via V1a and the p-MOS transistor 211 and the n-MOS transistor 212 that are disposed in proximity to each other in the logic substrate 20 and receive respective potentials different from each other. The shield electrode 213 receives, for example, a predetermined fixed potential (e.g., 0 V). As illustrated in part (B) of FIG. 2, the semiconductor layer 21 serving as the shield electrode 213 has, in a plan view, for example, a frame shape that is continuous along an inner edge of the unit pixel P and surrounds the two p-MOPS transistors 211 and the three n-MOS transistors 212 provided in the unit pixel P. The semiconductor layer 21 serving as the shield electrode 213 is provided with, for example, an n-well. A surface of the semiconductor layer 21 is provided with a contact layer 213C including an n-type semiconductor region (n⁺) for applying a fixed potential.

Provided in the interlayer insulating layer 221 are one or more wiring layers (e.g., a wiring layer 222), the through vias V1a and V1b, and vias V2 and V3. The through vias V1a and V1b are provided through the semiconductor layer 21 in the Z-axis direction. The one or more wiring layers (e.g., the wiring layer 222) are provided to supply a voltage to be applied to the semiconductor substrate 11, the light receiving element 12, or the like and to extract the carriers generated in the light receiving element 12. Specifically, for example, a part of wirings in the wiring layer 222 is electrically coupled to the contact layer 15 via the through via V1a. A part of the wirings in the wiring layer 222 is electrically coupled to the contact layer 16 via the through via V1b. In addition, the one or more wiring layers (e.g., the wiring layer 222) are provided to supply a voltage to be applied to the semiconductor layer 21, or the two p-MOS transistors 211, the three n-MOS transistors 212, and the shield electrode 213 provided in the semiconductor layer 21. Specifically, for example, a part of the wirings in the wiring layer 222 is electrically coupled, via the via V2, to: the gate electrode 211G, the source region 211S, and the drain region 211D of each of the two p-MOS transistors 211; the gate electrode 212G, the source region 212S, and the drain region 212D of each of the three n-MOS transistors 212; and the unillustrated well contact electrode. A part of the wirings in the wiring layer 222 is electrically coupled to the shield electrode 213 via the via V3.

The interlayer insulating layer 221 includes, for example, a monolayer film including one of silicon oxide (SiOₓ), TEOS, silicon nitride (SiNₓ), silicon oxynitride (SiOₓN_{y}), or the like, or a stacked film including two or more thereof.

The gate electrodes 211G and 212G and the wiring layer 222 each include, for example, aluminum (Al), copper (Cu), tungsten (W), or the like.

The vias V1a, V1b, V2, and V3 each include, for example, a metal material having a light blocking property, such as tungsten (W), aluminum (Al), copper (Cu), cobalt (Co), nickel (Ni), or titanium (Ti), or a silicon compound thereof.

On a side of the light receiving surface (the second surface 11S2) of the semiconductor substrate 11, for example, a microlens 33 is provided with a protective layer 31 and a color filter 32 interposed therebetween, for example, for each of the unit pixels P.

The microlens 33 collects light incident from above the microlens 33 to the light receiving element 12. The microlens 33 includes, for example, silicon oxide (SiOₓ) or the like.

### (1-2. Manufacturing Method of Photodetector)

The photodetector 1 of the present embodiment is manufacturable, for example, in the following manner.

FIGs. 5A to 5F illustrate a manufacturing method of the photodetector 1 in process order. First, as illustrated in FIG. 5A, the sensor substrate 10 is formed. Thereafter, as illustrated in FIG. 5B, the interlayer insulating layer 221 is formed on the first surface 11S1 of the semiconductor substrate 11, following which the semiconductor layer 21 is bonded to the interlayer insulating layer 221.

Thereafter, as illustrated in FIG. 5C, an STI (Shallow Trench Isolation) is formed by processing the surface of the semiconductor layer 21. Thereafter, as illustrated in FIG. 5D, an FTI (Full Trench Isolation) structure is formed by processing the semiconductor layer 21, and the semiconductor layer 21 is separated into a plurality of islands.

Thereafter, as illustrated in FIG. 5E, the interlayer insulating layer 221 is so formed as to embed the semiconductor layer 21 separated into the plurality of islands. Thereafter, as illustrated in FIG. 5F, the interlayer insulating layer 221 is polished by a CMP (Chemical Mechanical Polishing) method to planarize the surface of the interlayer insulating layer 221 and to expose the surface of the semiconductor layer 21.

Thereafter, the gate electrodes 211G and 212G, the source region 211S and the drain region 211D each including the p-type semiconductor region (p⁺), the source region 212S and the drain region 212D each including the n-type semiconductor region (n⁺), the contact layer 213C including the n-type semiconductor region (n⁺), and the well contact electrode including the n-type semiconductor region (n⁺) or the p-type semiconductor region (p⁺) are formed on the surface of the semiconductor layer 21 by a typical CMOS manufacturing technique. Thereafter, the interlayer insulating layer 221, the through vias V1a and V1b, the vias V2 and V3, the wiring layer 222, etc. are formed. The photodetector 1 illustrated in FIG. 1 is thus completed.

### (1-3. Action and Effects)

The photodetector 1 of the present embodiment includes the shield electrode 213, to which the predetermined fixed potential is to be applied, between the plurality of transistors (e.g., the two p-MOS transistors 211 and the three n-MOS transistors 212) and the through via V1a that are adjacent to each other. The through via V1a is electrically coupled to the contact layer 15 provided on the first surface 11S1 of the semiconductor substrate 11 to apply a predetermined potential to the light receiving section 13. This blocks an influence of a high voltage applied to the through via V1a. This is described below.

Recently, a SPAD element has been developed that is improved in function by bonding, on a SPAD pixel, another substrate on which a transistor is mounted. Meanwhile, because the SPAD element uses a high voltage, in a case where a wiring to which a high voltage is applied is laid out on a side surface of the transistor provided on the other substrate, this influences channel formation, leading to a concern of degradation of a transistor characteristic.

To address this, in the present embodiment, the shield electrode 213, to which the predetermined fixed potential is to be applied, is provided between the plurality of transistors (e.g., the two p-MOS transistors 211 and the three n-MOS transistors 212) and the via V1a that is electrically coupled to the light receiving section 13 via the contact layer 15 and to which a high voltage is to be applied. This blocks an influence of the high voltage applied to the through via V1a, on the two p-MOS transistors 211 and the three n-MOS transistors 212.

Accordingly, the photodetector 1 of the present embodiment makes it possible to improve degradation of a characteristic of a plurality of transistors (e.g., the two p-MOS transistors 211 and the three n-MOS transistors 212) caused by an influence of a high voltage to be applied to a through wiring (e.g., the through via V1a) electrically coupled to the light receiving element 12.

In addition, in the photodetector 1 of the present embodiment, the shield electrode 213 is provided between the plurality of transistors (e.g., the two p-MOS transistors 211 and the three n-MOS transistors 212) and the through via V1a that are adjacent to each other. This makes it possible to reduce an arrangement distance between the through via V1a and the plurality of transistors (e.g., the two p-MOS transistors 211 and the three n-MOS transistors 212). Accordingly, it is possible to improve area efficiency of the transistors in the logic substrate 20. In addition, it is possible to increase the number of the transistors mounted on the logic substrate 20 and the semiconductor layer 21. As a result, it is possible to provide a higher-function photodetector.

Next, descriptions are given of Modification examples 1 to 9, an application example, and practical application examples of the present disclosure. Hereinafter, components similar to those of the foregoing embodiment are denoted by the same reference numerals, and descriptions thereof are omitted as appropriate.

### <2. Modification Examples>

### (2-1. Modification Example 1)

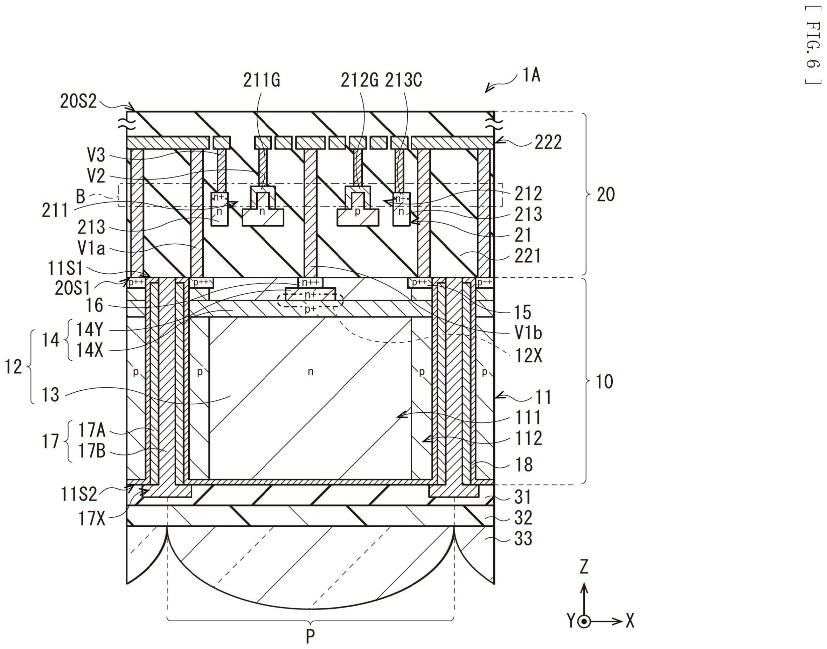

FIG. 6 schematically illustrates an example of a cross-sectional configuration of a photodetector (a photodetector 1A) according to Modification example 1 of the present disclosure. As with in the foregoing embodiment, the photodetector 1A is to be applied to, for example, a distance image sensor (the distance image apparatus 1000) that performs distance measurement by the ToF method, an image sensor, or the like.

In the foregoing embodiment, a transistor having a planar configuration is described as an example of each of the plurality of transistors (e.g., the two p-MOS transistors 211 and the three n-MOS transistors 212) provided on the side of the first surface 11S1 of the sensor substrate 10; however, this is non-limiting. For example, a part or all of the plurality of transistors (e.g., the two p-MOS transistors 211 and the three n-MOS transistors 212) provided on the side of the first surface 11S1 of the sensor substrate 10 may each have a three-dimensional structure. Specifically, the two p-MOS transistors 211 and the three n-MOS transistors 212 may each have a Fin-FET structure as illustrated in FIG. 6.

As described above, in the photodetector 1A of the present modification example, the plurality of transistors each having the three-dimensional structure such as the Fin-FET structure is provided on the side of the first surface 11S1 of the sensor substrate 10. In addition to the effects of the foregoing embodiment, this makes it possible to increase a channel width (W) and a channel length (L) in the same layout area, as compared with a case where the transistors each having the planar configuration are provided. Alternatively, this makes it possible to increase the number of the transistors mounted on the logic substrate 20 and the semiconductor layer 21. It is thus possible to provide a higher-function photodetector.

### (2-2. Modification Example 2)

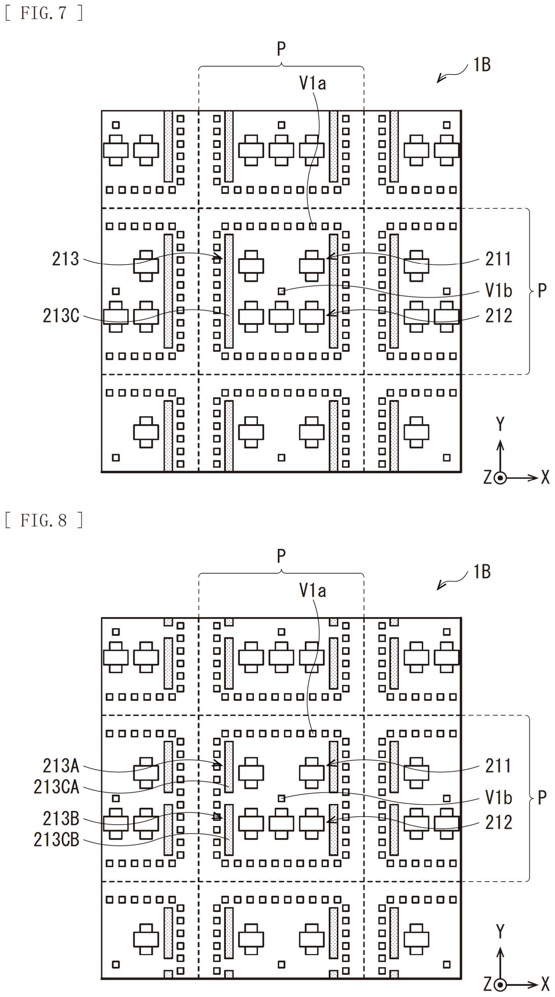

FIGs. 7 to 13 each schematically illustrate an example of a plan configuration of a photodetector (a photodetector 1B) according to Modification example 2 of the present disclosure. As with the foregoing embodiment, the photodetector 1B is to be applied to, for example, a distance image sensor (the distance image apparatus 1000) that performs distance measurement by the ToF method, an image sensor, or the like.

In the foregoing embodiment, the example has been described in which the shield electrode 213 is provided that has the frame shape continuously surrounding the two p-MOS transistors 211 and the three n-MOS transistors 212 provided in the unit pixel P; however, this is non-limiting. For example, the shield electrode 213 may be selectively provided only in a channel-length direction of the two p-MOS transistors 211 and the three n-MOS transistors 212 provided in the unit pixel P. This achieves a certain level of blocking effect.

Specifically, as illustrated in FIG. 7, the shield electrode 213 may be provided only in the channel-length direction (a Y-axis direction) of the two p-MOS transistors 211 and the three n-MOS transistors 212 provided in the unit pixel P. This makes it possible to further improve the area efficiency of the transistors in the logic substrate 20, as compared with the photodetector 1 of the foregoing embodiment.

Alternatively, the shield electrodes 213 provided along the respective channel lengths of the two p-MOS transistors 211 and the three n-MOS transistors 212 may each form a well and a contact layer 213C each having the same polarity as the transistor adjacent thereto. For example, as illustrated in FIG. 8, a shield electrode 213A adjacent to the p-MOS transistor 211 includes a contact layer 213CA including an n-well and an n-type semiconductor region (n⁺). A shield electrode 213B adjacent to the n-MOS transistor 212 includes a contact layer 213CB including a p-well and a p-type semiconductor region (p⁺). This makes it possible to apply, to each of the shield electrodes 213A and 213B, a fixed potential according to the corresponding one, of the p-MOS transistors 211 and the n-MOS transistors 212, that is adjacent thereto. It is thus possible to improve a blocking effect of the shield electrodes 213A and 213B.

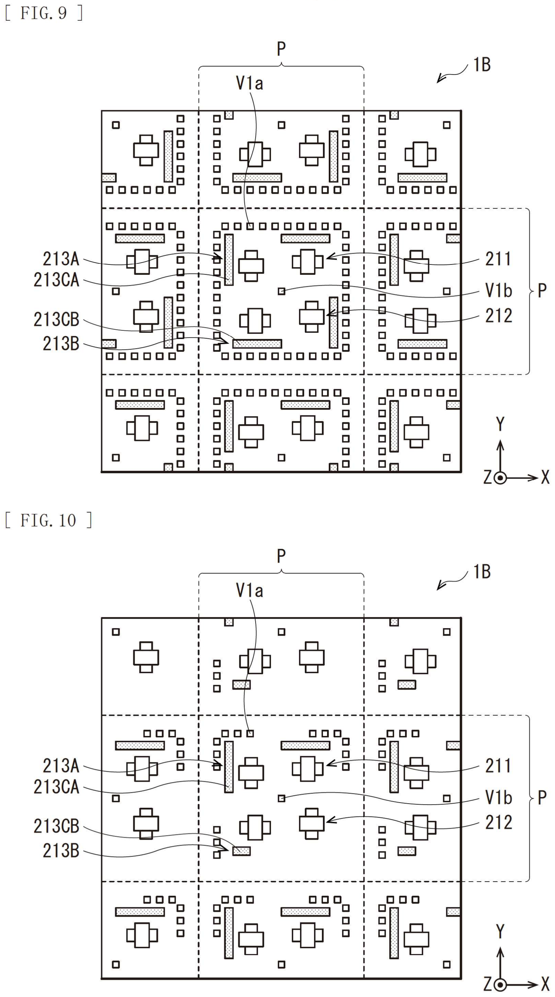

Note that, as illustrated in FIG. 9, the respective channel lengths of the two p-MOS transistors 211 and the three n-MOS transistors 212 provided in the unit pixel P may extend in directions (e.g., an X-axis direction, the Y-axis direction, etc.) different from each other. In this case, the shield electrodes 213A and 213B are each provided along the channel length of corresponding one, of the p-MOS transistors 211 and the n-MOS transistors 212, that is adjacent thereto.

Further, in the foregoing embodiment, the example has been described in which the through via V1a is so provided along the inner edge of the unit pixel P in a plan view as to surround the two p-MOS transistors 211 and the three n-MOS transistors 212 provided in the unit pixel P; however, this is non-limiting. As illustrated in FIG. 10, it is sufficient that the through via V1a is provided at a predetermined position in the unit pixel P. In this case, as illustrated in FIG. 10, the shield electrodes 213A and 213B are each selectively provided only between the through via V1a provided at the predetermined position and corresponding one, of the p-MOS transistors 211 and the n-MOS transistors 212, provided in proximity to the through via V1a. This makes it possible to further improve the area efficiency of the transistors in the logic substrate 20, as compared with the photodetector 1 of the foregoing embodiment.

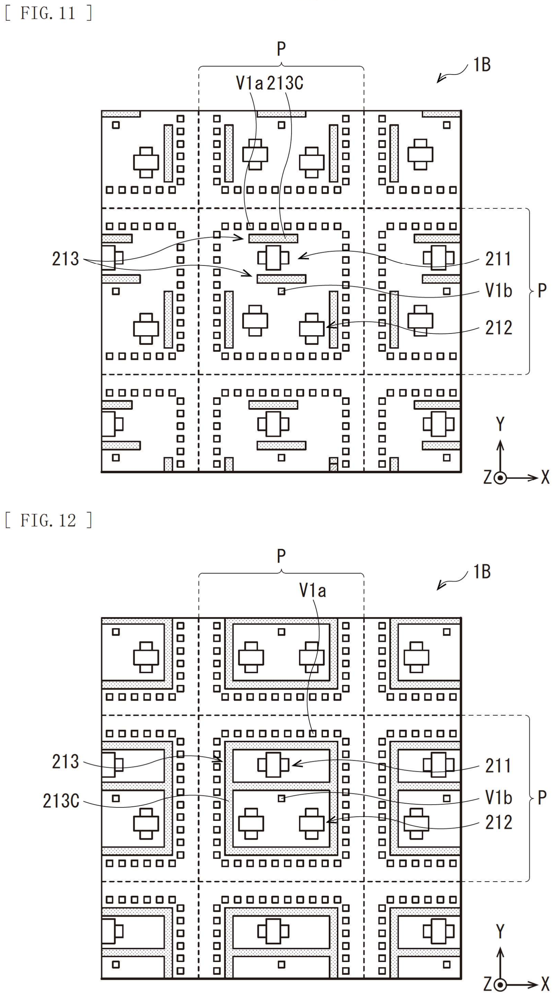

Further, in the foregoing embodiment, the example has been described in which the shield electrode 231 is provided only between the through via V1a and the two p-MOS transistors 211 and the three n-MOS transistors 212; however, this is non-limiting. As illustrated in FIG. 11, the shield electrode 213 may further be provided along the channel length between the channel of the p-MOS transistor 211 and the through via V1b in proximity thereto. This further improves the area efficiency of the transistors in the logic substrate 20, and also improves degradation of the characteristic of the transistors caused by an influence of a high voltage applied to the through via V1b electrically coupled to the multiplication section 14.

Note that, as illustrated in FIG. 12, the shield electrode 213 provided between the p-MOS transistor 211 and the through via V1b in proximity thereto may be continuous with the shield electrode 213 provided between the through via V1a and the two p-MOS transistors 211 and the three n-MOS transistors 212 provided in the unit pixel P.

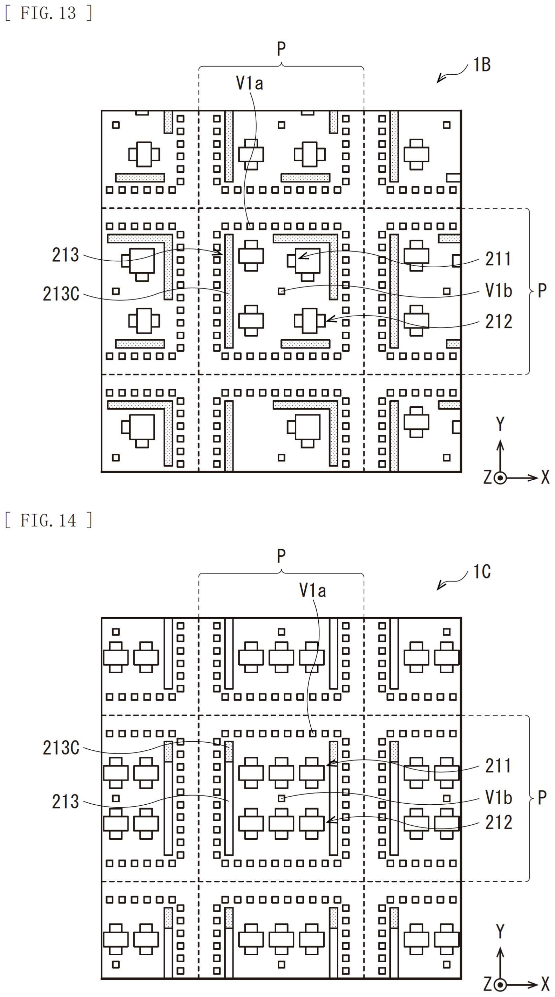

Further, in the foregoing embodiment, etc., the example has been described in which the p-MOS transistors 211 and the n-MOS transistors 212 each have the channel extending in one direction (e.g., the X-axis direction or the Y-axis direction); however, this is non-limiting. For example, as illustrated in FIG. 13, the channel of each of the p-MOS transistors 211 and the n-MOS transistors 212 may have, for example, an L-shape. This makes it possible to improve the characteristic of each of the p-MOS transistors 211 and the n-MOS transistors 212.

### (2-3. Modification Example 3)

FIGs. 14 to 16 each schematically illustrate an example of a plan configuration of a photodetector (a photodetector 1C) according to Modification example 3 of the present disclosure. As with the foregoing embodiment, the photodetector 1C is to be applied to, for example, a distance image sensor (the distance image apparatus 1000) that performs distance measurement by the ToF method, an image sensor, or the like.

In the foregoing embodiment, the example has been described in which, for example, the contact layer 213C including the n-type semiconductor region (n⁺) is provided on the entire surface of the semiconductor layer 21 forming the shield electrode 213; however, this is non-limiting.

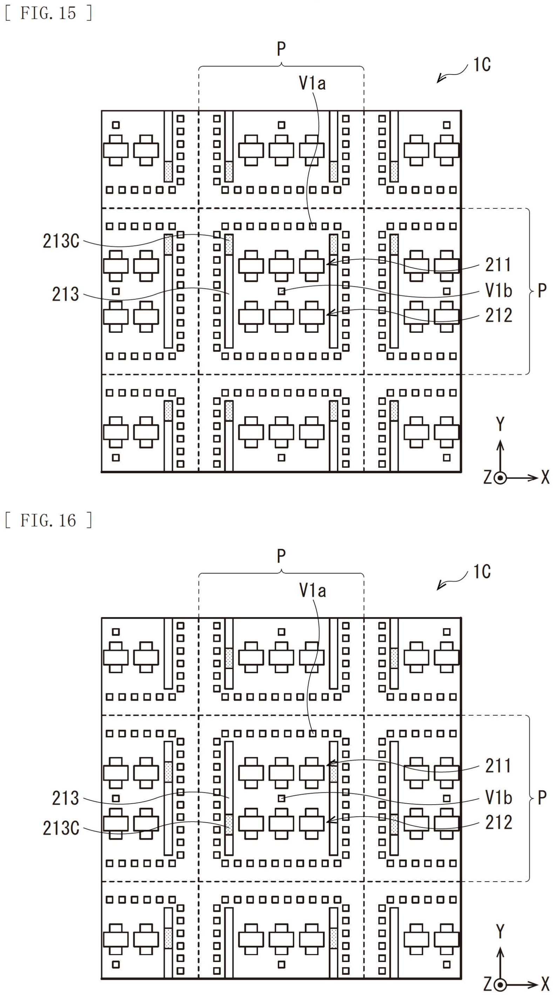

For example, as illustrated in FIG. 14, the contact layer 213C may be provided on a portion of the surface of the semiconductor layer 21 forming the shield electrode 213. As illustrated in FIG. 15, the contact layer 213C provided on a portion of the surface of the semiconductor layer 21 may be provided at each of two or more locations on the surface of the semiconductor layer 21 serving as one island. In addition, the contact layer 213C provided on a portion of the surface of the semiconductor layer 21 is not particularly limited in its position, as illustrated in FIG. 16. Further, the contact layer 213C may be omitted. Note that the contact layer 213C being provided on the entire surface of the semiconductor layer 21 as in the foregoing embodiment makes it possible to reduce a potential fluctuation of the shield electrode 213.

### (2-4. Modification Example 4)

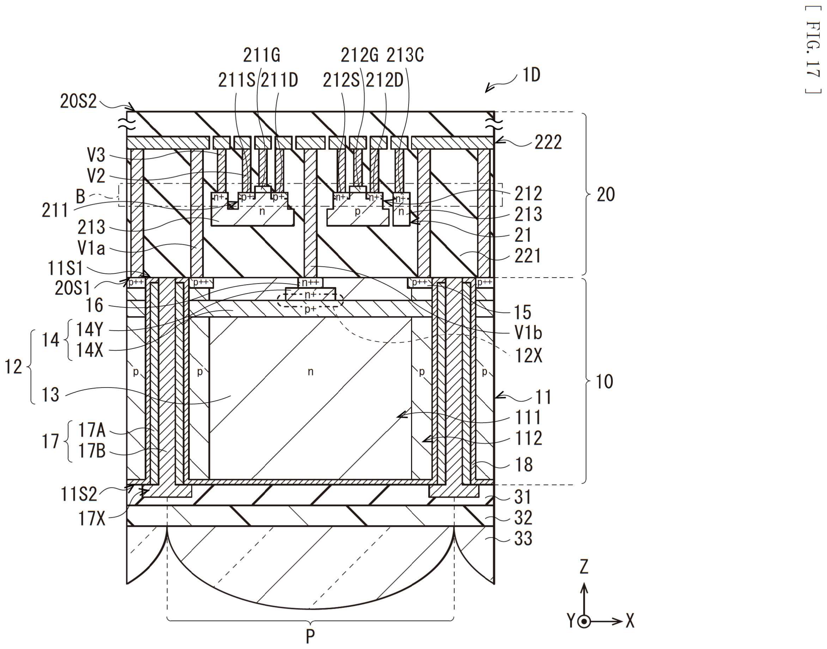

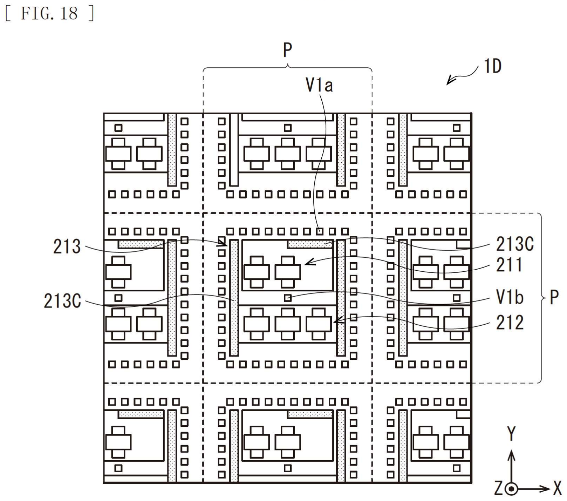

FIG. 17 schematically illustrates an example of a cross-sectional configuration of a photodetector (a photodetector 1D) according to Modification example 4 of the present disclosure. FIG. 18 schematically illustrates a plan configuration corresponding to that of the region B of the photodetector 1D illustrated in FIG. 17. As with the foregoing embodiment, the photodetector 1D is to be applied to, for example, a distance image sensor (the distance image apparatus 1000) that performs distance measurement by the ToF method, an image sensor, or the like.

In the foregoing embodiment, the example has been described in which the plurality of transistors (e.g., the two p-MOS transistors 211 and the three n-MOS transistors 212) provided in the unit pixel P and the shield electrode 213 are provided in the semiconductor layers 21 that are independent from each other; however, this is non-limiting.

In the photodetector 1D of the present modification example, a part (e.g., the three n-MOS transistors 212) of the plurality of transistors provided in the unit pixel P and the shield electrode 213 are provided in the continuous semiconductor layer 21. In the present modification example, the contact layer 213C provided on the surface of the shield electrode 213 and including the n-type semiconductor region (n⁺) is usable as a well contact electrode for the semiconductor layer 21 in which the three n-MOS transistors 212 are provided. This makes it possible to further improve the area efficiency of the transistors in the logic substrate 20, as compared with the photodetector 1 of the foregoing embodiment. Further, the photodetector 1D of the present modification example makes it possible to further improve the function and the characteristic of the readout circuit.

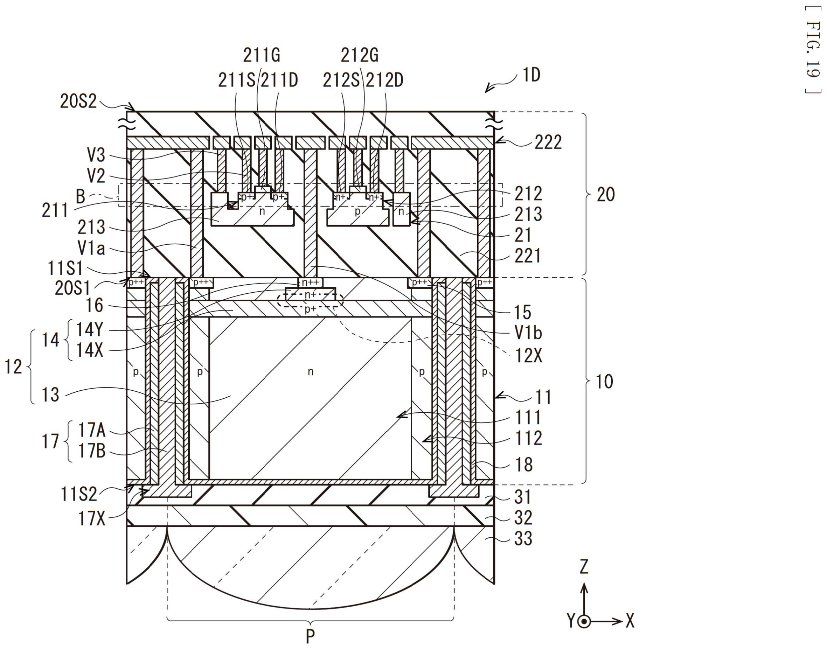

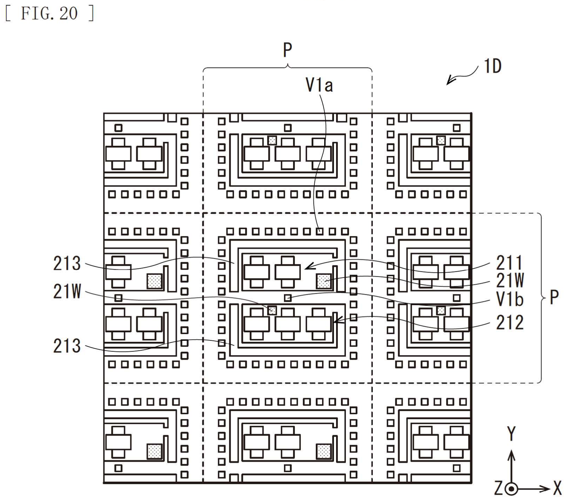

FIG. 19 schematically illustrates another example of the cross-sectional configuration of the photodetector (the photodetector 1D) according to Modification example 4 of the present disclosure. FIG. 20 schematically illustrates a plan configuration corresponding to that of the region B of the photodetector 1D illustrated in FIG. 19.

Further, in the photodetector 1D in which a part (e.g., the three n-MOS transistors 212) of the plurality of transistors provided in the unit pixel P and the shield electrode 213 are provided in the continuous semiconductor layer 21, the n-type semiconductor region (n⁺) or the p-type semiconductor region (p⁺) provided on the surface of the shield electrode 213 may be omitted. In this case, a fixed potential is applicable via the well to each of the shield electrodes 213A and 213B, by using, as corresponding one of the contact layers 213CA and 213CB, a well contact electrode 21W provided in the semiconductor layer 21 in which corresponding one of the two p-MOS transistors 211 and the three n-MOS transistors 212 is provided. Such a configuration also makes it possible to further improve the area efficiency of the transistors in the logic substrate 20. In addition, it is possible to further improve the function and the characteristic of the readout circuit. In addition, it is possible to decrease a wiring density in the logic substrate 20, and to thus improve a pixel response characteristic.

### (2-5. Modification Example 5)

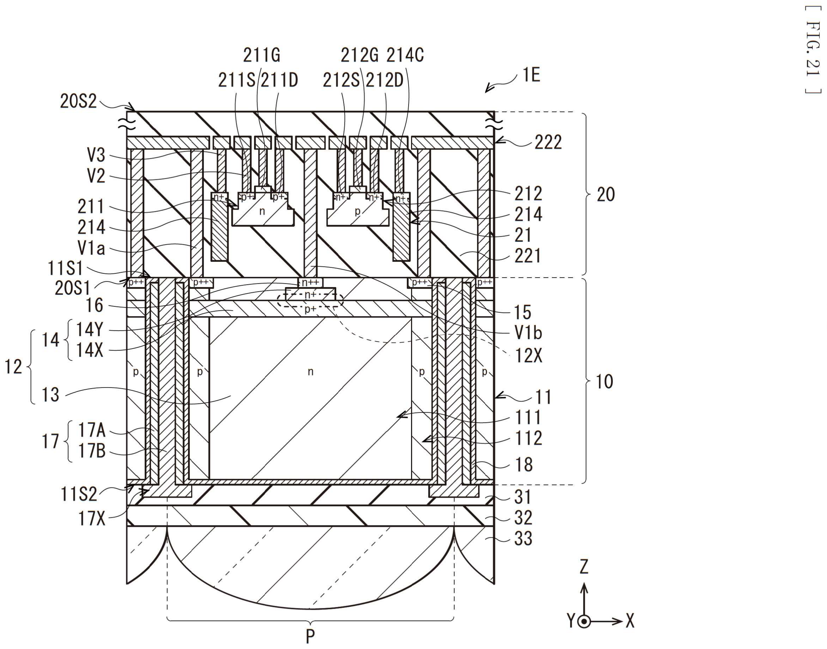

FIG. 21 schematically illustrates an example of a cross-sectional configuration of a photodetector (a photodetector 1E) according to Modification example 5 of the present disclosure. As with the foregoing embodiment, the photodetector 1E is to be applied to, for example, a distance image sensor (the distance image apparatus 1000), that performs distance measurement by the ToF method, an image sensor, or the like.

In the foregoing embodiment, the example has been described in which the shield electrode 213 is formed using the semiconductor layer 21. Meanwhile, in the present modification example, a polysilicon (Poly-Si) film is embedded in the interlayer insulating layer 221, which is used as a shield electrode 214. A contact layer 214C including an n-type semiconductor region (n⁺) is provided on a surface of the Poly-Si film, and a fixed potential is applied to the shield electrode 214 via the contact layer 214C. Alternatively, the shield electrode 214 may be formed using epitaxial silicon including a p-type or n-type impurity. This makes it possible to adjust the shielding effect in a depth direction (the Y-axis direction) as desired, which makes it possible to, for example, maximize the shielding effect.

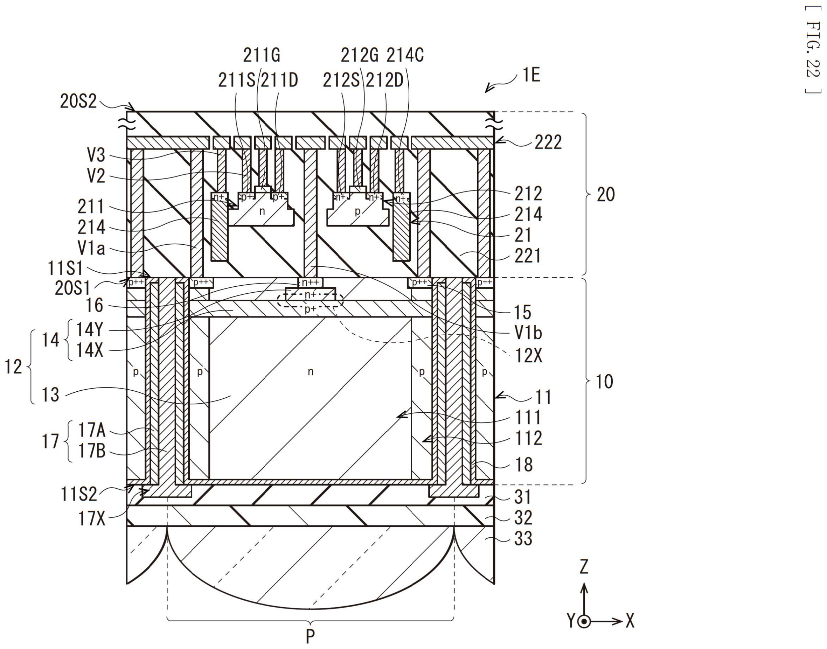

As illustrated in FIG. 22, the fixed potential may be applied to the shield electrode 214 by causing the semiconductor layer 21 provided with the plurality of transistors (e.g., the three n-MOS transistors 212) provided in the unit pixel P to be in contact with the Poly-Si film, and applying the fixed potential to the shield electrode 214 via the well of the semiconductor layer 21, as in Modification example 4 described above. This makes it possible to decrease the wiring density in the logic substrate 20, and to thus improve the pixel response characteristic.

### (2-6. Modification Example 6)

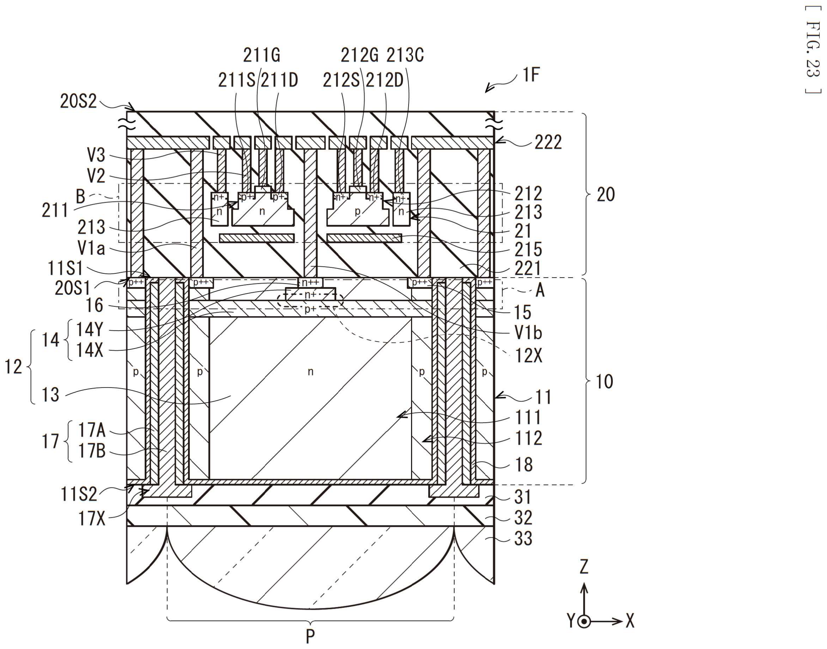

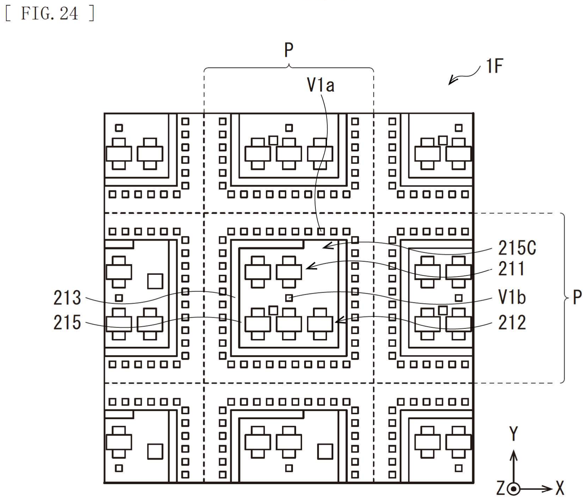

FIG. 23 schematically illustrates an example of a cross-sectional configuration of a photodetector (a photodetector 1F) according to Modification example 6 of the present disclosure. FIG. 24 schematically illustrates a plan configuration corresponding to that of the region B of the photodetector 1F illustrated in FIG. 23. As with the foregoing embodiment, the photodetector 1F is to be applied to, for example, a distance image sensor (the distance image apparatus 1000) that performs distance measurement by the ToF method, an image sensor, or the like.

In the photodetector 1F of the present modification example, a shield electrode 215 is further provided on a back surface side of the semiconductor layer 21. The shield electrode 215 is provided to block an influence of an electric field flowing around from the back surface side of the semiconductor layer 21, and corresponds to a specific example of a "second shield electrode" in Modification example 6 of the present disclosure. The shield electrode 215 includes, for example, a Poly-Si film, and is to receive a predetermined fixed potential. Specifically, as illustrated in FIG. 24, the shield electrode 215 includes, for example, a contact part 215C in contact with the semiconductor layer 21 in which the plurality of transistors (the two p-MOS transistors 211 and the three n-MOS transistors 212) is formed. This allows for application of the fixed potential via the well of the semiconductor layer 21.

In the photodetector 1F of the present modification example, it is thus possible to further improve the degradation of the characteristic of the plurality of transistors (e.g., the two p-MOS transistors 211 and the three n-MOS transistors 212), as compared with the photodetector 1 of the foregoing embodiment.

### (2-7. Modification Example 7)

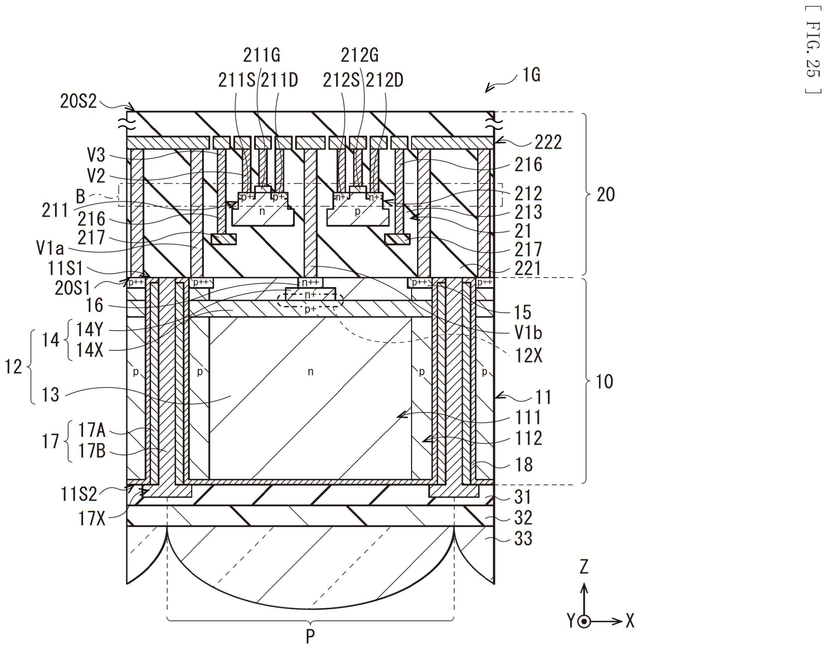

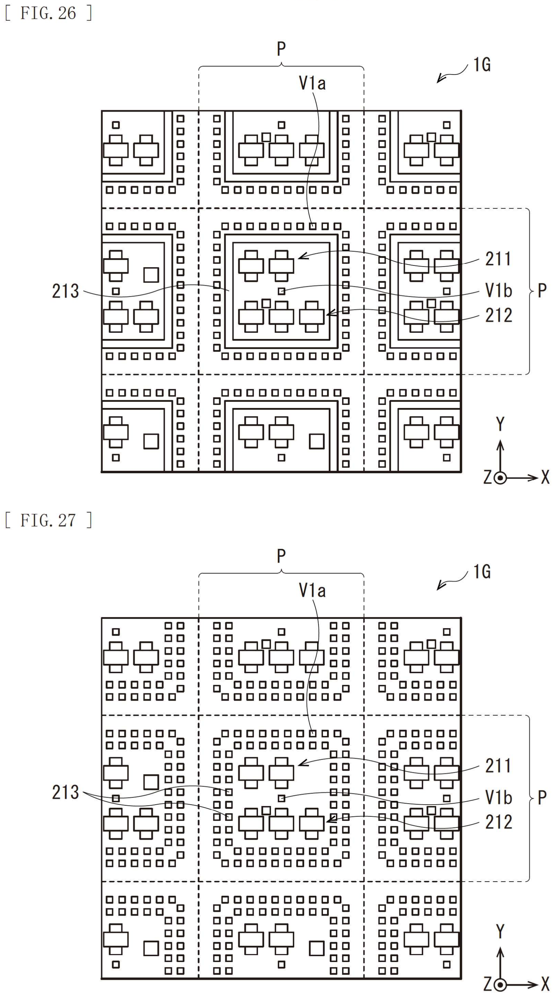

FIG. 25 schematically illustrates an example of a cross-sectional configuration of a photodetector (a photodetector 1G) according to Modification example 7 of the present disclosure. FIG. 26 schematically illustrates an example of a plan configuration corresponding to that of the region B of the photodetector 1G illustrated in FIG. 25. FIG. 27 schematically illustrates another example of the plan configuration corresponding to that of the region B of the photodetector 1G illustrated in FIG. 25. As with the foregoing embodiment, the photodetector 1F is to be applied to, for example, a distance image sensor (the distance image apparatus 1000) that performs distance measurement by the ToF method, an image sensor, or the like.

In the foregoing embodiment, the example has been described in which the shield electrode 213 is formed using the semiconductor layer 21. Meanwhile, in the present modification example, a metal film is embedded in the interlayer insulating layer 221, which is used as a shield electrode 216. In this case, the via V3 may be extended to a predetermined depth and may be used as the shield electrode 216. This makes it possible to adjust the shielding effect in the depth direction (the Y-axis direction) as desired, which makes it possible to, for example, maximize the shielding effect.

Alternatively, in order to adjust the depth of the shield electrode 216, for example, a stopper film 217 including a silicon nitride film (SiNₓ) may be formed at a predetermined depth in the interlayer insulating layer 221.

Further, for example, as illustrated in FIG. 26, the shield electrode 216 may have, for example, a frame shape that is continuous along the inner edge of the unit pixel P to surround the two p-MOS transistors 211 and the three n-MOS transistors 212 provided in the unit pixel P. Alternatively, as illustrated in FIG. 27, the shield electrode 216 may be formed discontinuously in dots.

### (2-8. Modification Example 8)

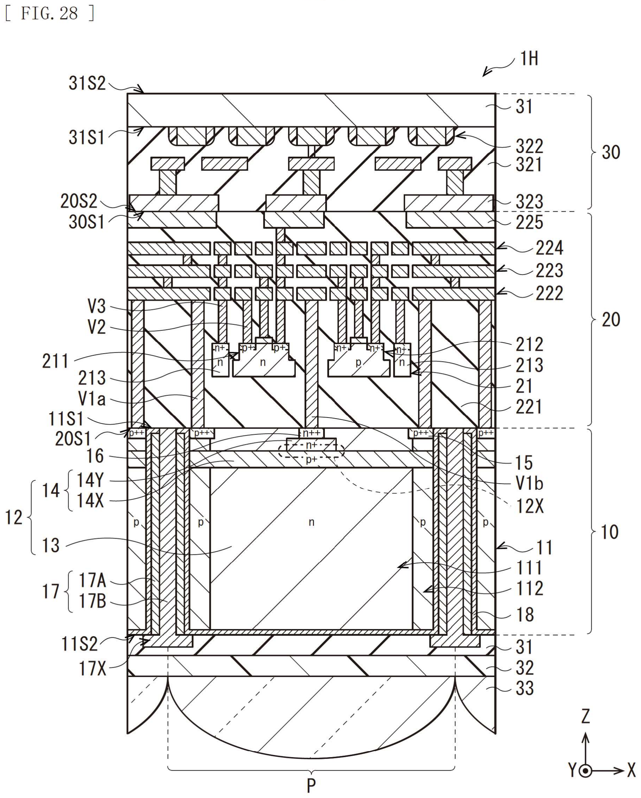

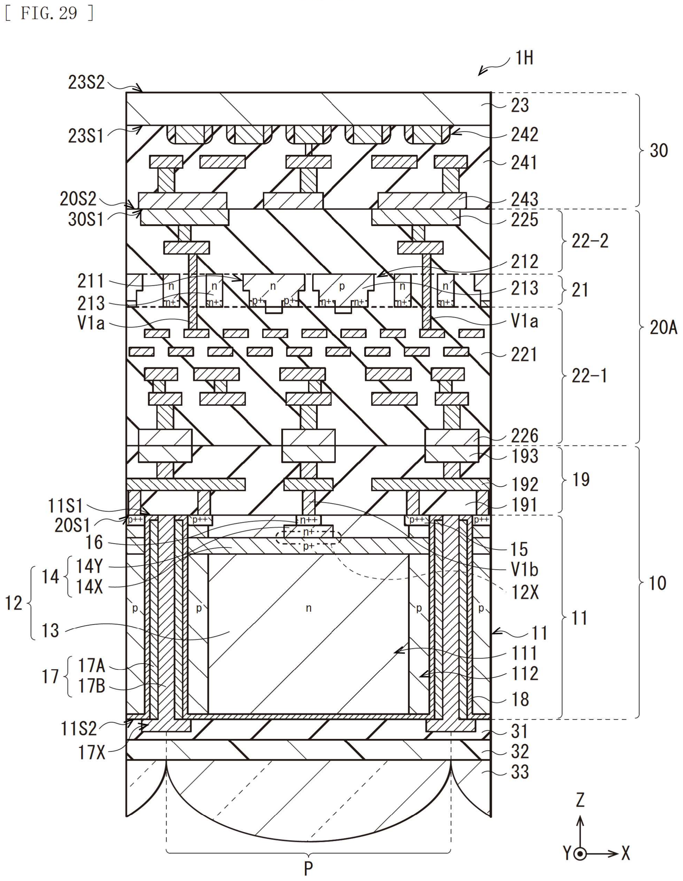

FIG. 28 schematically illustrates an example of a cross-sectional configuration of a photodetector (a photodetector 1H) according to Modification example 8 of the present disclosure. FIG. 29 schematically illustrates another example of the cross-sectional configuration of the photodetector (the photodetector 1H) according to Modification example 8 of the present disclosure. As with the foregoing embodiment, the photodetector 1H is to be applied to, for example, a distance image sensor (the distance image apparatus 1000) that performs distance measurement by the ToF method, an image sensor, or the like.

In the foregoing embodiment, the example has been described in which the two substrates, i.e., the sensor substrate 10 and the logic substrate 20, are stacked on each other; however, this is non-limiting. For example, in the foregoing embodiment, for example, the bias voltage application section 110 and the logic substrate 20 including the readout circuit that outputs the pixel signal based on the carriers outputted from the unit pixel P of the pixel array section 100A, the vertical drive circuit, the column signal processing circuit, the horizontal drive circuit, the output circuit, and the like are stacked on the side of the first surface 11S1 of the sensor substrate 10. However, for example, the readout circuit and the other logic circuits may be provided on different substrates, and they may be stacked in order on the side of the first surface 11S1 of the sensor substrate 10.

Specifically, in the photodetector 1H of the present Modification example 8, a readout circuit substrate 20A provided with a plurality of transistors constituting a readout circuit is stacked on the side of the first surface 11S1 of the sensor substrate 10. In addition, for example, a logic substrate 20B including the bias voltage application section 110, the vertical drive circuit, the column signal processing circuit, the horizontal drive circuit, the output circuit, and the like is further stacked on the side of the first surface 11S1 of the sensor substrate 10, with the readout circuit substrate 20A interposed therebetween. In the present modification example, the readout circuit substrate 20A corresponds to a specific example of a "second substrate" in Modification example 8 of the present disclosure, and the logic substrate 20B corresponds to a specific example of a "third substrate" in Modification example 8 of the present disclosure.

In addition, the plurality of transistors (e.g., the two p-MOS transistors 211 and the three n-MOS transistors 212) constituting the readout circuit may be provided on the opposite side to the surface facing the sensor substrate 10, as in the foregoing embodiment. Alternatively, as illustrated in FIG. 29, such a plurality of transistors may be provided on a side of the surface facing the sensor substrate 10. That is, the sensor substrate 10 and the readout circuit substrate 20A may be stacked on each other in a face-to-face manner as illustrated in FIG. 28, or may be stacked on each other in a face-to-back manner as illustrated in FIG. 29.

The photodetector 1H employing face-to-face stacking includes the readout circuit substrate 20A in which a wiring layer (e.g., wiring layers 222, 223, and 224) including one or more wirings is formed in the interlayer insulating layer 221 on the front surface side of the semiconductor layer 21, and in which a plurality of pad parts 225 is embedded in a surface, of an interlayer insulating layer 191, opposed to the logic substrate 20B. The logic substrate 20B includes a semiconductor substrate 23 and an interlayer insulating layer 241. The semiconductor substrate 23 includes a pair of opposed surfaces (a front surface 23S1 and a back surface 23S2). The interlayer insulating layer 241 is formed on the front surface 23S1 of the semiconductor substrate 23. Formed in the interlayer insulating layer 241 are gates 242 of a plurality of transistors provided on the front surface 23S1 of the semiconductor substrate 23 or one or more wiring layers. A plurality of pad parts 243 is embedded in a surface, of the interlayer insulating layer 241, opposed to the readout circuit substrate 20A. In the photodetector 1H, hybrid bonding (e.g., Cu-Cu bonding) is performed between the pad part 225 and the pad part 243. This allows the readout circuit substrate 20A and the logic substrate 20B to be electrically coupled to each other.

In the photodetector 1H employing the face-to-back stacking, a multilayer wiring layer 19 is provided on the side of the first surface 11S1 of the semiconductor substrate 11. In the multilayer wiring layer 19, a wiring layer 192 is formed in the interlayer insulating layer 191. The wiring layer 192 includes one or more wirings. A plurality of pad parts 193 is embedded in a surface, of the interlayer insulating layer 191, on the opposite side to the side of the semiconductor substrate 11. In the readout circuit substrate 20A, a multilayer wiring layer 22-1 is provided on the front surface side of the semiconductor layer 21 on which the plurality of transistors is formed, and a multilayer wiring layer 22-2 is formed on a back surface side thereof. A plurality of pad parts 226 is embedded in a surface, of the interlayer insulating layer 221, opposed to the sensor substrate 10 on a side of the multilayer wiring layer 22-1. The plurality of pad parts 225 is embedded in a surface, of the interlayer insulating layer 221, opposed to the logic substrate 20B on a side of the multilayer wiring layer 22-2. The logic substrate 20B includes the semiconductor substrate 23 and the interlayer insulating layer 241. The semiconductor substrate 23 includes the pair of opposed surfaces (the front surface 23S1 and the back surface 23S2). The interlayer insulating layer 241 is formed on the front surface 23S1 of the semiconductor substrate 23. Formed in the interlayer insulating layer 241 are the gates 242 of the plurality of transistors provided on the front surface 23S1 of the semiconductor substrate 23 or one or more wiring layers. The plurality of pad parts 243 is embedded in the surface, of the interlayer insulating layer 241, opposed to the readout circuit substrate 20A. In the photodetector 1H, hybrid bonding (e.g., Cu-Cu bonding) is performed between the pad part 193 and the pad part 226, and between the pad part 225 and the pad part 243. This allows the sensor substrate 10 and the readout circuit substrate 20A to be electrically coupled to each other, and allows the readout circuit substrate 20A and the logic substrate 20B to be electrically coupled to each other.

As described above, in the photodetector 1H of the present modification example, two or more substrates (e.g., the readout circuit substrate 20A and the logic substrate 20B) are stacked on the sensor substrate 10. This makes it possible to increase the number of circuits mountable on the photodetector 1H. It is thus possible to provide a higher-function photodetector.

### (2-9. Modification Example 9)

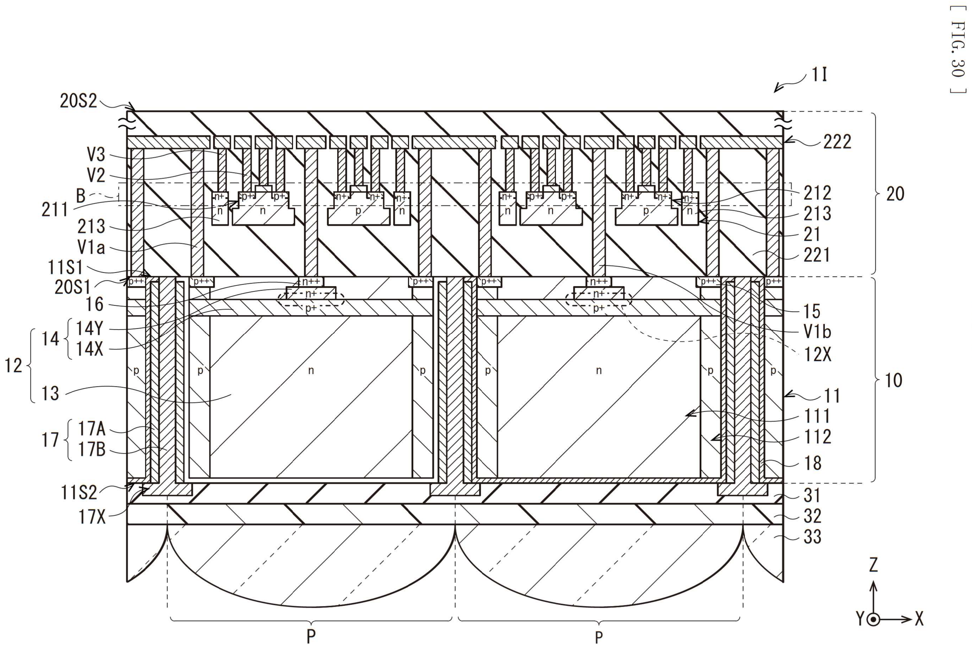

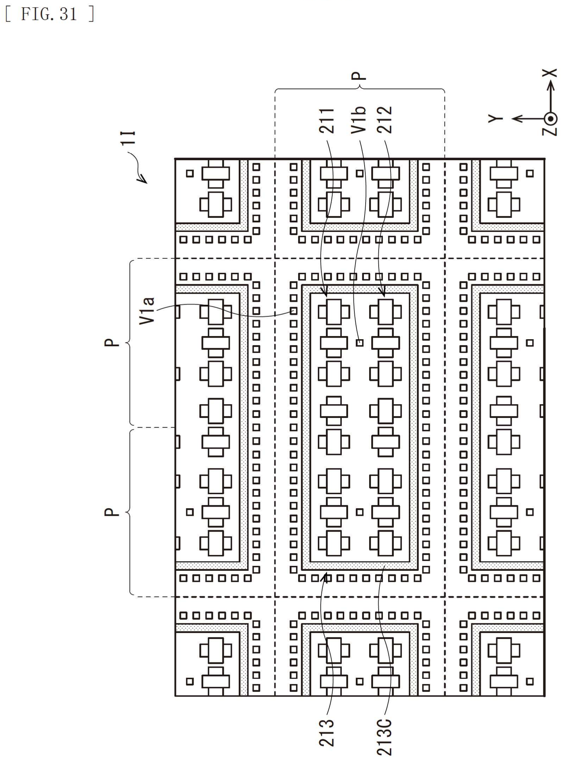

FIG. 30 schematically illustrates an example of a cross-sectional configuration of a photodetector (a photodetector 1I) according to Modification example 9 of the present disclosure. FIG. 31 schematically illustrates an example of a plan configuration corresponding to that of the region B of the photodetector 1I illustrated in FIG. 30. As with the foregoing embodiment, the photodetector 1I is to be applied to, for example, a distance image sensor (the distance image apparatus 1000) that performs distance measurement by the ToF method, an image sensor, or the like.

In the foregoing embodiment, the example has been described in which one readout circuit is provided in one unit pixel P; however, this is non-limiting. For example, as illustrated in FIGs. 30 and 31, two unit pixels P adjacent to each other in the row direction or the column direction may share one readout circuit. Other than this, for example, four unit pixels P adjacent to each other in two rows and two columns, or six unit pixels P adjacent to each other in two rows and three columns may share one readout circuit. That is, a cycle of the plurality of unit pixels P arranged in an array on the sensor substrate 10 and a cycle of the plurality of readout circuits provided on the logic substrate 20 may be different from each other.

### (Other Modification Examples)

In the embodiment and Modification examples 1 to 9 described above, the example has been described in which the shield electrode (e.g., the shield electrode 213) shields between the plurality of transistors (e.g., the two p-MOS transistors 211 and the three n-MOS transistors 212) constituting the readout circuit and the through vias V1a and V1b adjacent thereto; however, this is non-limiting. The present technology makes it possible to achieve similar effects also in, for example, a photodetector in which, other than the readout circuit, a circuit or a device other than a pixel readout circuit, such as a transistor performing circuit drive control or pixel selection is disposed in the region B.

### <3. Application Example>

FIG. 32 illustrates an example of a schematic configuration of a distance image apparatus 1000 as an electronic apparatus including the photodetector (e.g., the photodetector 1) according to the embodiment and Modification examples 1 to 9 described above. The distance image apparatus 1000 corresponds to a specific example of a "distance measurement apparatus" of the present disclosure.

The distance image apparatus 1000 includes, for example, a light source device 1100, an optical system 1200, the photodetector 1, an image processing circuit 1300, a monitor 1400, and a memory 1500.

The distance image apparatus 1000 receives light (modulated light or pulse light) projected from the light source device 1100 toward an irradiation target 2000 and reflected by a surface of the irradiation target 2000, thereby acquiring a distance image corresponding to a distance to the irradiation target 2000.

The optical system 1200 includes one or a plurality of lenses, and guides image light (incident light) from the irradiation target 2000 to the photodetector 1 to form an image on a light receiving surface (a sensor unit) of the photodetector 1.

The image processing circuit 1300 performs image processing for constructing the distance image on the basis of a distance signal supplied from the photodetector 1, and the distance image (image data) obtained by the image processing is supplied to the monitor 1400 and displayed, or is supplied to the memory 1500 and stored (recorded).

In the distance image apparatus 1000 configured as described above, application of the above-described photodetector (e.g., the photodetector 1) makes it possible to calculate the distance to the irradiation target 2000 only on the basis of the light receiving signal from the highly stable unit pixel P, and to generate a highly accurate distance image. That is, it is possible for the distance image apparatus 1000 to acquire a more accurate distance image.

### <4. Practical Application Examples>

### (Example of Practical Application to Endoscopic Surgery System)

The technique (the present technology) according to the present disclosure is applicable to various products. For example, the technique according to the present disclosure may be applied to an endoscopic surgery system.

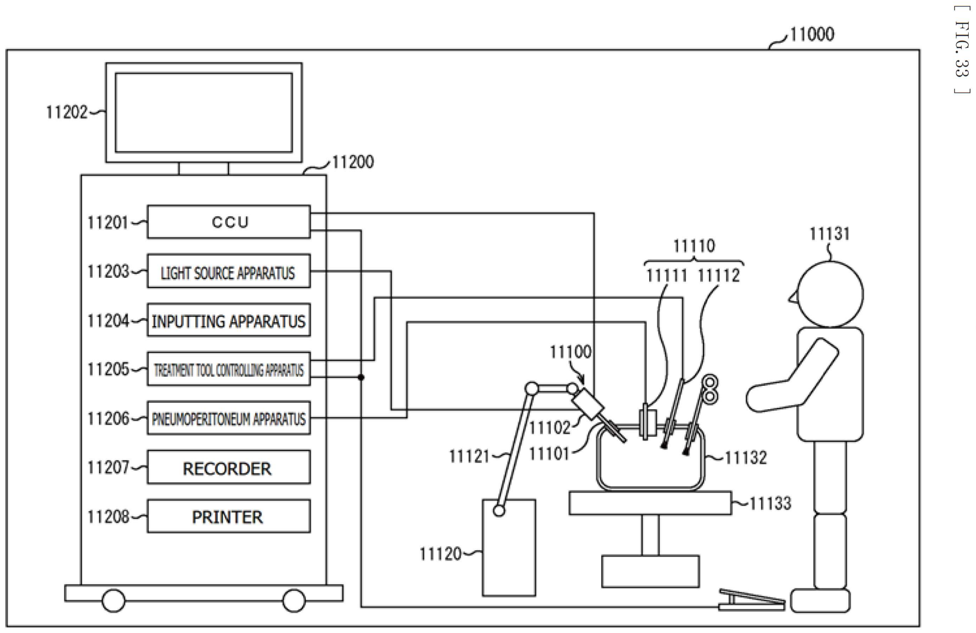

FIG. 33 is a view depicting an example of a schematic configuration of an endoscopic surgery system to which the technology according to an embodiment of the present disclosure (present technology) can be applied.

In FIG. 33, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

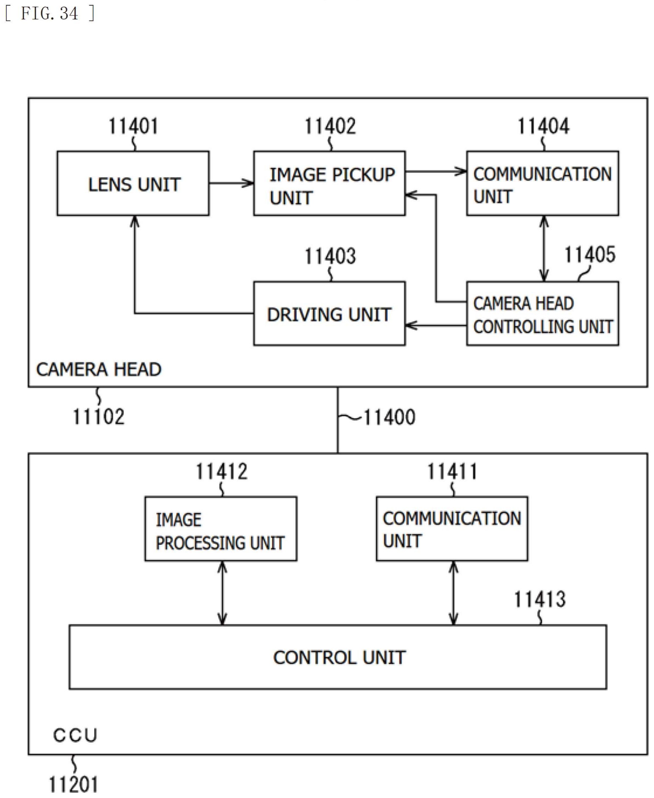

FIG. 34 is a block diagram depicting an example of a functional configuration of the camera head 11102 and the CCU 11201 depicted in FIG. 33.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technique according to the present disclosure may be applied has been described above. The technique according to the present disclosure may be applied to the image pickup unit 11402 among the configurations described above. Applying the technique according to the present disclosure to the image pickup unit 11402 improves detection accuracy.

Note that although the endoscopic surgery system has been described here as an example, the technique according to the present disclosure may be additionally applied to, for example, a microscopic surgery system or the like, other than the above.

### (Example of Practical Application to Mobile Body)

The technique according to the present disclosure is applicable to various products. For example, the technique according to the present disclosure may be achieved as a device mounted on any type of mobile body such as a vehicle, an electric vehicle, a hybrid electric vehicle, a motorcycle, a bicycle, a personal mobility, an airplane, a drone, a vessel, a robot, a construction machine, or an agricultural machine (tractor).

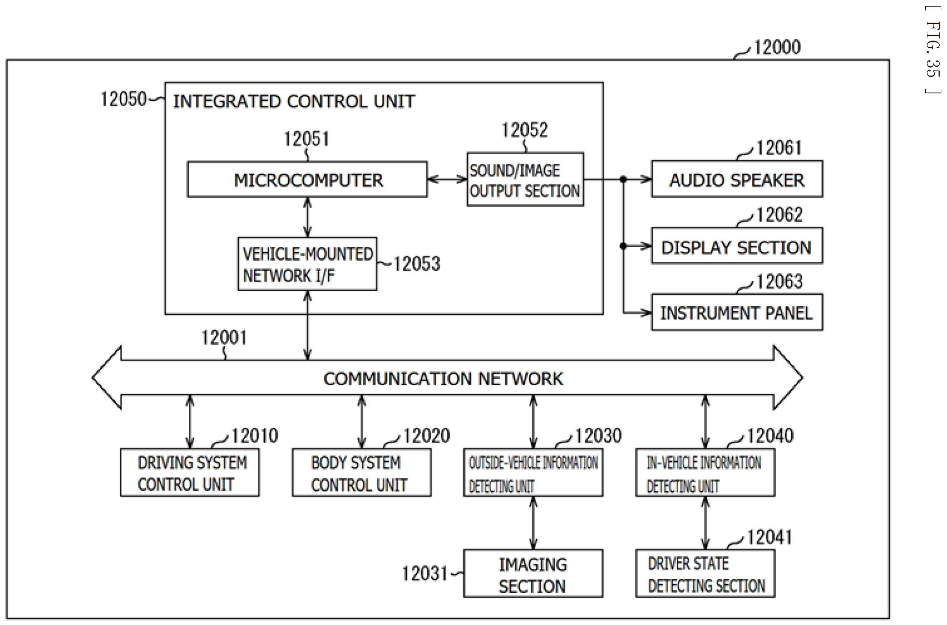

FIG. 35 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 35, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 35, an audio speaker 12061, a display section 12062, and an instrument panel 12063 are illustrated as the output device. The display section 12062 may, for example, include at least one of an on-board display and a head-up display.

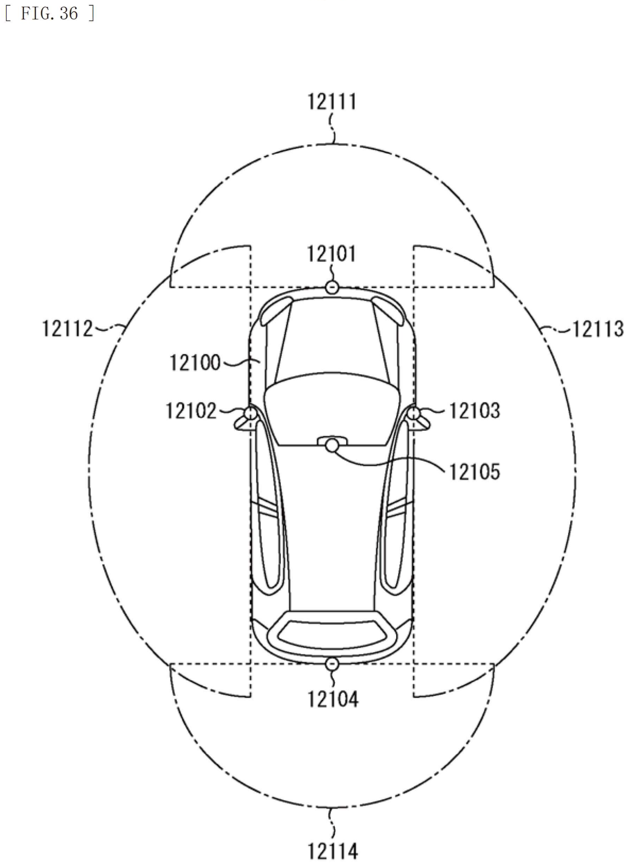

FIG. 36 is a diagram depicting an example of the installation position of the imaging section 12031.

In FIG. 36, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 36 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the mobile body control system to which the technique according to the present disclosure may be applied has been described above. The technique according to the present disclosure may be applied to the imaging section 12031 among the configurations described above. Specifically, the photodetector (e.g., the photodetector 1) according to any of the embodiment and Modification examples 1 to 9 described above is applicable to the imaging section 12031. Applying the technique according to the present disclosure to the imaging section 12031 makes it possible to obtain a high-resolution captured image with less noise, and thus makes it possible to perform highly accurate control using the captured image in the mobile body control system.

Although the description has been given above with reference to the embodiment, Modification examples 1 to 9, the application example, and the practical application examples, the contents of the present disclosure are not limited to the above-described embodiments and the like. The contents of the present disclosure may be modified in a variety of ways. For example, the photodetector of the present disclosure does not have to include all of the components described in the above embodiments and the like, and may include other layers. For example, in a case where the photodetector 1 is to detect light other than visible light (e.g., near-infrared light (IR)), the color filter 32 may be omitted.

In addition, a polarity of the semiconductor region constituting the photodetector according to the present disclosure may be inverted. Further, in the photodetector according to the present disclosure, holes may serve as the signal charge.

Furthermore, as long as the photodetector according to the present disclosure is in a state in which the avalanche multiplication occurs by applying a reverse-bias between the anode and the cathode, the respective potentials are not limited.

In addition, the foregoing embodiment and the like exemplify the semiconductor substrate 11 including silicon; however, the semiconductor substrate 11 may include, for example, germanium (Ge), or a compound semiconductor (e.g., silicon germanium (SiGe)) of silicon (Si) and germanium (Ge).

Further, the shape of the unit pixel P is not limited to the rectangular shape. For example, the unit pixel P may have an octagonal shape, and the plurality of unit pixels P constituting the pixel array section 100A may be arranged in a honeycomb shape.

Note that the effects described regarding the foregoing embodiment and the like are examples. Any other effect may be achieved, and any other effect may be included in addition.

Note that the present disclosure may have any of the following configurations. According to the present technology having any of the following configurations, the one or more shield electrodes, to which the fixed potential is applied, are provided at least in a portion of the region between the one or more transistors and the first and the second through wirings. The first and the second through wirings are adjacent to the one or more transistors. The one or more transistors are provided on the side of the first surface of the first substrate. The first through wiring is provided through the semiconductor layer in which the one or more transistors are provided, and is electrically coupled to the first contact layer provided on the first surface of the first substrate on which the light receiving element is provided. The second through wiring is provided through the semiconductor layer, and is electrically coupled to the second contact layer provided on the first surface of the first substrate on which the light receiving element is provided. This makes it possible to block an influence of a high voltage applied to the light receiving element, and to improve a characteristic of the one or more transistors.
(1) A photodetector including:
   a first substrate having a first surface and a second surface opposed to each other and including a pixel array section in which a plurality of pixels is arranged in an array in an in-plane direction;
   a light receiving element including a light receiving section and a multiplication section, the light receiving section being provided inside the first substrate for each of the pixels and generating carriers corresponding to a received light amount by photoelectric conversion, the multiplication section performing avalanche multiplication of the carriers generated in the light receiving section;
   a first contact layer provided on the first surface of the first substrate and electrically coupled to the light receiving section;
   a second contact layer provided on the first surface of the first substrate and electrically coupled to the multiplication section;
   a second substrate stacked on a side of the first surface of the first substrate and including a semiconductor layer in which one or more transistors are provided;
   a first through wiring provided through the semiconductor layer in a stacking direction and electrically coupled to the first contact layer;
   a second through wiring provided through the semiconductor layer in the stacking direction and electrically coupled to the second contact layer; and
   one or more first shield electrodes that are provided at least in a portion of a region between the one or more transistors and the first and the second through wirings, and to which a fixed potential is applied, the first and the second through wirings being adjacent to the one or more transistors.
(2) The photodetector according to (1) described above, in which
   the one or more transistors are provided for each of the pixels, and
   the one or more first shield electrodes are provided continuously along an inner edge of corresponding one of the pixels to surround the one or more transistors.
(3) The photodetector according to (1) or (2) described above, in which the one or more first shield electrodes are provided along a channel-length direction of the one or more transistors.
(4) The photodetector according to any one of (1) to (3) described above, in which
   the one or more transistors include a p-MOS transistor and an n-MOS transistor,
   a p-type contact layer is provided in the one or more first shield electrodes provided along a channel-length direction of the p-MOS transistor, and
   an n-type contact layer is provided in the one or more first shield electrodes provided along a channel-length direction of the n-MOS transistor.
(5) The photodetector according to any one of (1) to (4) described above, in which
   the one or more first shield electrodes are formed from the semiconductor layer, and
   a p-type or n-type contact layer is provided on a surface of the semiconductor layer.
(6) The photodetector according to (5) described above, in which the p-type or n-type contact layer is provided over all of the surface of the semiconductor layer.
(7) The photodetector according to any one of (1) to (6) described above, in which the one or more first shield electrodes are continuous with the semiconductor layer in which the one or more transistors are provided.
(8) The photodetector according to (7) described above, in which the one or more first shield electrodes each also serve as a well contact electrode that applies a fixed potential to the semiconductor layer.
(9) The photodetector according to (7) or (8) described above, in which the fixed potential is supplied to the one or more first shield electrodes via the semiconductor layer in which the one or more transistors are provided.
(10) The photodetector according to any one of (1) to (7) described above, in which the one or more first shield electrodes include polysilicon, or epitaxial silicon including a p-type or n-type impurity.
(11) The photodetector according to (10) described above, in which the one or more first shield electrodes are in contact with the semiconductor layer.
(12) The photodetector according to any one of (1) to (7) described above, in which the one or more first shield electrodes include a metal material.
(13) The photodetector according to any one of (1) to (12) described above, further including a second shield electrode that is provided between the first substrate and the semiconductor layer and to which a fixed potential is applied.
(14) The photodetector according to (13) described above, in which the second shield electrode is electrically coupled to the semiconductor layer.
(15) The photodetector according to any one of (1) to (14) described above, further including a third semiconductor substrate stacked on a surface, of the second substrate, opposite to a surface on which the first substrate is stacked.
(16) The photodetector according to (15) described above, in which the second substrate and the third semiconductor substrate are electrically coupled to each other by hybrid bonding.
(17) The photodetector according to any one of (1) to (16) described above, in which the one or more transistors form a readout circuit that outputs a pixel signal based on the carriers outputted from the light receiving element.
(18) The photodetector according to (17) described above, in which the readout circuit is provided for each of the pixels or for each two or more, of the pixels, that are adjacent to each other.
(19) The photodetector according to any one of (1) to (18) described above, further including
   a pixel separation section provided between the plurality of pixels adjacent to each other to extend between the first surface and the second surface of the first substrate, the pixel separation section electrically separating, from each other, the plurality of pixels adjacent to each other, in which
   the first contact layer is provided along the pixel separation section and around each of the plurality of pixels.
(20) The photodetector according to (19) described above, in which
   the first through wiring is provided continuously or discontinuously around each of the plurality of pixels, and
   the one or more first shield electrodes are provided continuously between the one or more transistors and the first through wiring.

The present application claims the benefit of Japanese Priority Patent Application JP2023-004149 filed with the Japan Patent Office on January 13, 2023, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A photodetector comprising:
a first substrate having a first surface and a second surface opposed to each other and including a pixel array section in which a plurality of pixels is arranged in an array in an in-plane direction;
a light receiving element including a light receiving section and a multiplication section, the light receiving section being provided inside the first substrate for each of the pixels and generating carriers corresponding to a received light amount by photoelectric conversion, the multiplication section performing avalanche multiplication of the carriers generated in the light receiving section;
a first contact layer provided on the first surface of the first substrate and electrically coupled to the light receiving section;
a second contact layer provided on the first surface of the first substrate and electrically coupled to the multiplication section;
a second substrate stacked on a side of the first surface of the first substrate and including a semiconductor layer in which one or more transistors are provided;
a first through wiring provided through the semiconductor layer in a stacking direction and electrically coupled to the first contact layer;
a second through wiring provided through the semiconductor layer in the stacking direction and electrically coupled to the second contact layer; and
one or more first shield electrodes that are provided at least in a portion of a region between the one or more transistors and the first and the second through wirings, and to which a fixed potential is applied, the first and the second through wirings being adjacent to the one or more transistors.

2. The photodetector according to claim 1, wherein
the one or more transistors are provided for each of the pixels, and
the one or more first shield electrodes are provided continuously along an inner edge of corresponding one of the pixels to surround the one or more transistors.

3. The photodetector according to claim 1, wherein the one or more first shield electrodes are provided along a channel-length direction of the one or more transistors.

4. The photodetector according to claim 1, wherein
the one or more transistors include a p-MOS transistor and an n-MOS transistor,
a p-type contact layer is provided in the one or more first shield electrodes provided along a channel-length direction of the p-MOS transistor, and
an n-type contact layer is provided in the one or more first shield electrodes provided along a channel-length direction of the n-MOS transistor.

5. The photodetector according to claim 1, wherein
the one or more first shield electrodes are formed from the semiconductor layer, and
a p-type or n-type contact layer is provided on a surface of the semiconductor layer.

6. The photodetector according to claim 5, wherein the p-type or n-type contact layer is provided over all of the surface of the semiconductor layer.

7. The photodetector according to claim 1, wherein the one or more first shield electrodes are continuous with the semiconductor layer in which the one or more transistors are provided.

8. The photodetector according to claim 7, wherein the one or more first shield electrodes each also serve as a well contact electrode that applies a fixed potential to the semiconductor layer.

9. The photodetector according to claim 7, wherein the fixed potential is supplied to the one or more first shield electrodes via the semiconductor layer in which the one or more transistors are provided.

10. The photodetector according to claim 1, wherein the one or more first shield electrodes include polysilicon, or epitaxial silicon including a p-type or n-type impurity.

11. The photodetector according to claim 10, wherein the one or more first shield electrodes are in contact with the semiconductor layer.

12. The photodetector according to claim 1, wherein the one or more first shield electrodes include a metal material.

13. The photodetector according to claim 1, further comprising a second shield electrode that is provided between the first substrate and the semiconductor layer and to which a fixed potential is applied.

14. The photodetector according to claim 13, wherein the second shield electrode is electrically coupled to the semiconductor layer.

15. The photodetector according to claim 1, further comprising a third semiconductor substrate stacked on a surface, of the second substrate, opposite to a surface on which the first substrate is stacked.

16. The photodetector according to claim 15, wherein the second substrate and the third semiconductor substrate are electrically coupled to each other by hybrid bonding.

17. The photodetector according to claim 1, wherein the one or more transistors form a readout circuit that outputs a pixel signal based on the carriers outputted from the light receiving element.

18. The photodetector according to claim 17, wherein the readout circuit is provided for each of the pixels or for each two or more, of the pixels, that are adjacent to each other.

19. The photodetector according to claim 1, further comprising
a pixel separation section provided between the plurality of pixels adjacent to each other to extend between the first surface and the second surface of the first substrate, the pixel separation section electrically separating, from each other, the plurality of pixels adjacent to each other, wherein
the first contact layer is provided along the pixel separation section and around each of the plurality of pixels.

20. The photodetector according to claim 19, wherein
the first through wiring is provided continuously or discontinuously around each of the plurality of pixels, and
the one or more first shield electrodes are provided continuously between the one or more transistors and the first through wiring.
